# EUROPEAN PATENT SPECIFICATION

(11) **EP 4 235 955 B1**
(45) Date of publication and mention of the grant of the patent: **11.02.2026**
(21) Application number: 21889043.2
(22) Date of filing: 21.10.2021
(51) Int. Cl.: H01Q 13/02, H01Q 19/08

(54) **HORN ANTENNA**
HORNANTENNE
ANTENNE CORNET

(30) Priority: 05.11.2020 JP 2020184794
(43) Date of publication of application: 30.08.2023
(73) Proprietor: Sony Semiconductor Solutions Corporation, Atsugi-shi, Kanagawa 243-0014 (JP)
(72) Inventor: YOSHINO, Yoshitaka, Atsugi-shi, Kanagawa 243-0014 (JP); TSUBOI, Satoru, Atsugi-shi, Kanagawa 243-0014 (JP)
(74) Representative: D Young & Co LLP
(86) International application number: PCT/JP2021/038882
(87) International publication number: WO 2022/097490

(56) References cited:
- WO-A1-2016/111107
- JP-A- 2002 171 119
- JP-A- 2012 175 624
- JP-A- 2019 201 379
- JP-A- 2019 201 379
- JP-A- 2020 058 002
- JP-A- H1 146 114
- SIEW BEE YEAP ET AL: "140-GHz 2x2 SIW horn array on LTCC", ANTENNAS AND PROPAGATION (APCAP), 2012 IEEE ASIA-PACIFIC CONFERENCE ON, IEEE, 27 August 2012 (2012-08-27), pages 279 - 280, XP032254271, ISBN: 978-1-4673-0666-9, DOI: 10.1109/APCAP.2012.6333254
- ZHANG YINGSONG ET AL: "Broadband implementation of SIW horn antenna with air-via dielectric slab", 2015 IEEE 4TH ASIA-PACIFIC CONFERENCE ON ANTENNAS AND PROPAGATION (APCAP), IEEE, 30 June 2015 (2015-06-30), pages 563 - 567, XP032844738, DOI: 10.1109/APCAP.2015.7374489
- CHOUDHURY SUVADEEP ET AL: "A Novel Methodology to Design Substrate Integrated Waveguide based H-plane Horns with Improved Radiations using Air Perforations", 2019 IEEE INDIAN CONFERENCE ON ANTENNAS AND PROPOGATION (INCAP), IEEE, 19 December 2019 (2019-12-19), pages 1 - 3, XP033790354, DOI: 10.1109/INCAP47789.2019.9134487
- CAI YANG ET AL: "Design of Compact Air-Vias-Perforated SIW Horn Antenna With Partially Detached Broad Walls", IEEE TRANSACTIONS ON ANTENNAS AND PROPAGATION, IEEE, USA, vol. 64, no. 6, 1 June 2016 (2016-06-01), pages 2100 - 2107, XP011612659, ISSN: 0018-926X, [retrieved on 20160530], DOI: 10.1109/TAP.2016.2542841

## Description

### Technical Field

The present technology relates to, for example, a horn antenna capable of transmitting or receiving millimeter-wave electromagnetic waves as defined in the appended claims.

### Background Art

In recent years, millimeter-wave modules for detecting people and obstacles, such as a radar, have been widely used mainly for in-vehicle applications. A phased patch antenna formed on a substrate is the mainstream of this type of antenna device. However, since radio waves are radiated in a direction perpendicular to the substrate surface in this antenna, it is difficult to reduce the thickness of the antenna.

Meanwhile, an antenna using a technology called a post-wall waveguide is known (see, for example, Patent Literature 1). The post-wall waveguide is a waveguide including a post wall formed by arranging a plurality of metal pillars (conductor posts) that electrically connects upper and lower conductors (copper foils) of a wiring board to each other. Since the post-wall waveguide has an antenna opening on the side surface of the wiring board, the thickness of the antenna can be reduced.

### Citation List

### Patent Literature

Patent Literature 1: Japanese Patent Application Laid-open No. 2012-175624 SIEW BEE YEAP ET AL: "140-GHz 2x2 SIW horn array on LTCC", ANTENNAS AND PROPAGATION (APCAP), 2012 IEEE ASIA-PACIFIC CONFERENCE ON, IEEE, 27 August 2012, pages 279-280, XP032254271, DOI: 10.1109/APCAP.2012.6333254 ISBN: 978-1-4673-0666-9, discusses an antenna based on substrate integrated waveguide (SIW) technique whereby the flare of the horn is designed in vertical steps of the LTCC layer.
JP 2019 201379 A (NGK SPARK PLUG CO) 21 November 2019 discusses a horn antenna including a waveguide portion and a horn portion.
ZHANG YINGSONG ET AL: "Broadband implementation of SIW horn antenna with air-via dielectric slab", 2015 IEEE 4TH ASIA-PACIFIC CONFERENCE ON ANTENNAS AND PROPAGATION (APCAP), IEEE, 30 June 2015, pages 563-567, XP032844738, DOI: 10.1109/ APCAP.2015.7374489, discusses a planar substrate integrated waveguide (SIW) horn antenna loaded with dielectric slab for bandwidth enhancement.
CHOUDHURY SUVADEEP ET AL: "A Novel Methodology to Design Substrate Integrated Waveguide based H-plane Horns with Improved Radiations using Air Perforations", 2019 IEEE INDIAN CONFERENCE ON ANTENNAS AND PROPOGATION (INCAP), IEEE, 19 December 2019, pages 1-3, XP033790354, DOI: 10.1109/INCAP47789.2019.9134487, discusses a substrate integrated waveguide (SIW) inspired H-plane sectoral horn.
CAI YANG ET AL: "Design of Compact Air-Vias-Perforated SIW Horn Antenna With Partially Detached Broad Walls", IEEE TRANSACTIONS ON ANTENNAS AND PROPAGATION, IEEE, USA, vol. 64, no. 6, 1 June 2016 (2016-06-01), pages 2100-2107, XP011612659, ISSN: 0018-926X, DOI: 10.1109/TAP .2016.2542841, discusses substrate-integrated waveguide (SIW) horn antenna with partially detached broad walls.

### Disclosure of Invention

### Technical Problem

However, in the post-wall waveguide antenna described in Patent Literature 1, since the antenna opening is limited by the width and thickness of the post waveguide, it is difficult to improve the antenna gain.

In view of the circumstances as described above, it is an object of the present technology to provide a post-wall waveguide horn antenna capable of improving the antenna gain.

### Solution to Problem

Various aspects and features of the present disclosure are defined in the appended claims.

A horn antenna according to an embodiment of the present technology includes: a waveguide portion; and a horn portion.

The waveguide portion includes a first dielectric block and a first post wall, the first post wall including a plurality of first conductive columnar bodies that passes through the first dielectric block and demarcating a first waveguide that extends in one axial direction.

The horn portion includes a first widening portion, the first widening portion being connected to one end of the waveguide portion in the one axial direction. The first widening portion includes a second dielectric block that is thicker than the first dielectric block and a second post wall that includes a plurality of second conductive columnar bodies and demarcates a second waveguide whose width increases as a distance from the first waveguide increases, the plurality of second conductive columnar bodies passing through the second dielectric block.

The first dielectric block and the second dielectric block may be formed by a common dielectric multilayer substrate. In this case, the first waveguide and the second waveguide are provided inside the dielectric multilayer substrate.

The first post wall further includes two first conductor layers that face each other across the first dielectric block and are connected to the plurality of first conductive columnar bodies.

The second post wall may further include two second conductor layers and interlayer connection portions. The two second conductor layers face each other across the second dielectric block and are connected to the plurality of second conductive columnar bodies. The interlayer connection portions electrically connect the first conductor layers and the second conductor layers to each other.

The horn antenna may further include a conductive shield layer. The shield layer is connected to one of the first conductor layers and one of the second conductor layers and covers the waveguide portion and the horn portion.

The horn portion includes a second widening portion that includes a third dielectric block and a third post wall. The third dielectric block is connected to one end of the second dielectric layer in the one axial direction and thicker than the second dielectric block. The third post wall includes a plurality of third conductive columnar bodies and demarcates a third waveguide whose width increases as a distance from the second waveguide increases, the plurality of third conductive columnar bodies passing through the third dielectric block.

The waveguide portion may include a plurality of air hole portions that is provided in the first dielectric block and has an opening width smaller than a wavelength of an electromagnetic wave propagating through the first dielectric block.

The horn portion includes a plurality of air hole portions. The plurality of air hole portions is provided in at least one of the second dielectric block or the third dielectric block and has an opening width smaller than a wavelength of an electromagnetic wave penetrating the second dielectric block and the third dielectric block.

The horn portion may further include a dielectric lens portion. The dielectric lens portion is provided on a side of one end in the one axial direction and formed by part of the plurality of air hole portions.

The horn antenna may further include a dielectric portion. The dielectric portion is connected to one end of the horn portion in the one axial direction and has a length along the one axial direction equal to or greater than a wavelength of an electromagnetic wave propagating the second waveguide.

The dielectric portion may include a plurality of air hole portions having an opening width smaller than a wavelength of an electromagnetic wave propagating the dielectric portion and a dielectric lens portion formed by part of the plurality of air hole portions.

The horn antenna may further include a power supply unit that includes a signal line to be connected to the first waveguide.

A horn antenna according to another embodiment of the present technology includes: a dielectric multilayer substrate; a waveguide portion; and a horn portion.

The dielectric multilayer substrate includes a side surface portion in which an antenna opening is formed.

The waveguide portion is provided inside the dielectric multilayer substrate. The waveguide portion includes two first conductor layers and a first post wall, the two first conductor layers facing each other in a thickness direction of the dielectric multilayer substrate with a first interval, the first post wall being provided between the two first conductor layers and demarcating a first waveguide that extends in one axial direction orthogonal to the thickness direction of the dielectric multilayer substrate.

The horn portion includes a first widening portion that is provided between the waveguide portion and the side surface portion. The first widening portion includes two second conductor layers and a second post wall, the two second conductor layers facing each other in the thickness direction of the dielectric multilayer substrate with a second interval larger than the first interval, the second post wall being provided between the two second conductor layers and demarcating a second waveguide whose width increases as a distance from the first waveguide increases.

### Brief Description of Drawings

[Fig. 1] Fig. 1 is a partially transparent perspective view showing a horn antenna according to a first embodiment.
[Fig. 2] Fig. 2 is a cross-sectional view taken along the line A-A in Fig. 1.
[Fig. 3] Fig. 3 is a plan view of a horn antenna according to the first embodiment.
[Fig. 4] Fig. 4 is a cross-sectional side view schematically showing a dielectric multilayer substrate constituting the horn antenna according to the first embodiment.
[Fig. 5] Fig. 5 is a schematic diagram describing a gap between conductive columnar bodies in the horn antenna according to the first embodiment.
[Fig. 6] Fig. 6 is a partially exploded perspective view showing a layer structure of a power supply unit in the horn antenna according to the first embodiment.
[Fig. 7] Fig. 7 is a front cross-sectional view of a main part of the power supply unit.
[Fig. 8] Fig. 8 is a schematic plan view of a main part of the power supply unit.
[Fig. 9] Fig. 9 is a schematic perspective view of an entire horn antenna according to a Comparative Example.
[Fig. 10] Fig. 10 is a cross-sectional side view of the central portion of the horn antenna according to the Comparative Example in the width direction.
[Fig. 11] Fig. 11 is a simulation result showing radiation characteristics of the horn antenna according to the Comparative Example.
[Fig. 12] Fig. 12 is a simulation result showing radiation characteristics of the horn antenna according to the first embodiment.
[Fig. 13] Fig. 13 is a diagram showing radiation patterns of the horn antenna according to the first embodiment and the horn antenna according to the Comparative Example in comparison with each other.
[Fig. 14] Fig. 14 is a partially transparent perspective view showing a horn antenna according to a second embodiment.
[Fig. 15] Fig. 15 is a simulation result showing the difference in radiation characteristics of an antenna with or without an air hole portion.
[Fig. 16] Fig. 16 is a schematic plan view showing a horn antenna according to a third embodiment.
[Fig. 17] Fig. 17 is a schematic plan view of a main portion of the horn antenna according to the third embodiment.
[Fig. 18] Fig. 18 is a schematic perspective view a horn antenna according to a fourth embodiment.
[Fig. 19] Fig. 19 is a schematic cross-sectional side view of the central portion of the horn antenna according to the fourth embodiment in the width direction.
[Fig. 20] Fig. 20 is a diagram describing an operation of a horn antenna that does not include a shield layer.
[Fig. 21] Fig. 21 is a simulation result showing radiation characteristics of the horn antenna according to the fourth embodiment.
[Fig. 22] Fig. 22 is a schematic plan view showing a horn antenna according to a fifth embodiment.
[Fig. 23] Fig. 23 is a simulation result showing radiation characteristics of the horn antenna according to the fifth embodiment.
[Fig. 24] Fig. 24 is a schematic plan view showing a horn antenna according to a sixth embodiment.
[Fig. 25] Fig. 25 is a simulation result showing radiation characteristics of the horn antenna according to the sixth embodiment
[Fig. 26] Fig. 26 is a simulation result showing radiation characteristics of the horn antenna according to the sixth embodiment.
[Fig. 27] Fig. 27 is a simulation result showing radiation characteristics of the horn antenna according to the sixth embodiment in the case where the length of a dielectric portion is set to 1.3 mm.
[Fig. 28] Fig. 28 is a diagram showing radiation patterns of the horn antenna according to the sixth embodiment in comparison with another structure.
[Fig. 29] Fig. 29 is a simulation result showing radiation characteristics of the horn antenna according to the sixth embodiment in the case where the length of a dielectric portion is set to 4.0 mm.
[Fig. 30] Fig. 30 is a simulation result showing radiation characteristics of the horn antenna according to the sixth embodiment in the case where the length of a dielectric portion is set to 5.2 mm.
[Fig. 31] Fig. 31 is a diagram showing radiation patterns of the horn antenna according to the sixth embodiment in comparison with another structure.
[Fig. 32] Fig. 32 is a schematic plan view showing an antenna device according to a seventh embodiment.
[Fig. 33] Fig. 33 is a partially transparent perspective view showing a horn antenna according to a Reference Example 1.
[Fig. 34] Fig. 34 is a cross-sectional side view of the central portion of the horn antenna according to the Reference Example 1 in the width direction.
[Fig. 35] Fig. 35 is a schematic plan view of the horn antenna according to the Reference Example 1.
[Fig. 36] Fig. 36 is a simulation result showing radiation characteristics of the horn antenna according to the Reference Example 1.
[Fig. 37] Fig. 37 is a schematic plan view showing a horn antenna according to a Reference Example 2.
[Fig. 38] Fig. 38 is a cross-sectional side view of the central portion of the horn antenna according to the Reference Example 2 in the width direction.
[Fig. 39] Fig. 39 is a simulation result showing radiation characteristics of the horn antenna according to the Reference Example 2.
[Fig. 40] Fig. 40 is a schematic plan view showing a horn antenna according to a Reference Example 3.
[Fig. 41] Fig. 41 is a cross-sectional side view of the central portion of the horn antenna according to the Reference Example 3 in the width direction.
[Fig. 42] Fig. 42 is a simulation result showing radiation characteristics of the horn antenna according to the Reference Example 3.
[Fig. 43] Fig. 43 is a simulation result showing radiation characteristics of the horn antenna according to the Reference Example 3.
[Fig. 44] Fig. 44 is a schematic plan view showing a horn antenna according to a Reference Example 4.
[Fig. 45] Fig. 45 is a cross-sectional side view of the central portion of the horn antenna according to the Reference Example 4 in the width direction.
[Fig. 46] Fig. 46 is a simulation result showing radiation characteristics of the horn antenna according to the Reference Example 4.
[Fig. 47] Fig. 47 is a simulation result showing radiation characteristics of the horn antenna according to the Reference Example 4.
[Fig. 48] Fig. 48 is a schematic plan view showing a horn antenna according to a Reference Example 5.
[Fig. 49] Fig. 49 is a simulation result showing radiation characteristics of the horn antenna according to the Reference Example 5.
[Fig. 50] Fig. 50 is a simulation result showing radiation characteristics of the horn antenna according to the Reference Example 5.
[Fig. 51] Fig. 51 is a schematic plan view showing a horn antenna according to a Reference Example 6.
[Fig. 52] Fig. 52 is a simulation result showing radiation characteristics of the horn antenna according to the Reference Example 6.
[Fig. 53] Fig. 53 is a simulation result showing radiation characteristics of the horn antenna according to the Reference Example 6.
[Fig. 54] Fig. 54 is a schematic plan view showing a horn antenna according to a Reference Example 7.
[Fig. 55] Fig. 55 is a simulation result showing radiation characteristics of the horn antenna according to the Reference Example 7.
[Fig. 56] Fig. 56 is a simulation result showing radiation characteristics of the horn antenna according to the Reference Example 7.
[Fig. 57] Fig. 57 is a schematic cross-sectional side view showing a horn antenna according to a Reference Example 8 and an enlarged view of a main part thereof.
[Fig. 58] Fig. 58 is a simulation result showing radiation characteristics of the horn antenna according to the Reference Example 8.
[Fig. 59] Fig. 59 is a simulation result showing radiation characteristics of the horn antenna according to the Reference Example 8.

### Mode(s) for Carrying Out the Invention

Hereinafter, embodiments according to the present technology will be described with reference to the drawings.

### <First embodiment>

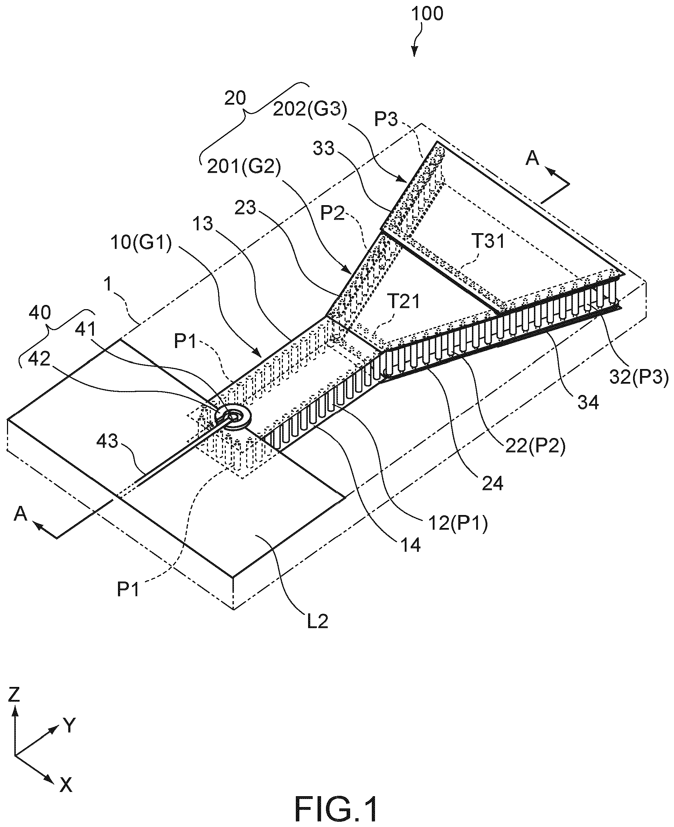

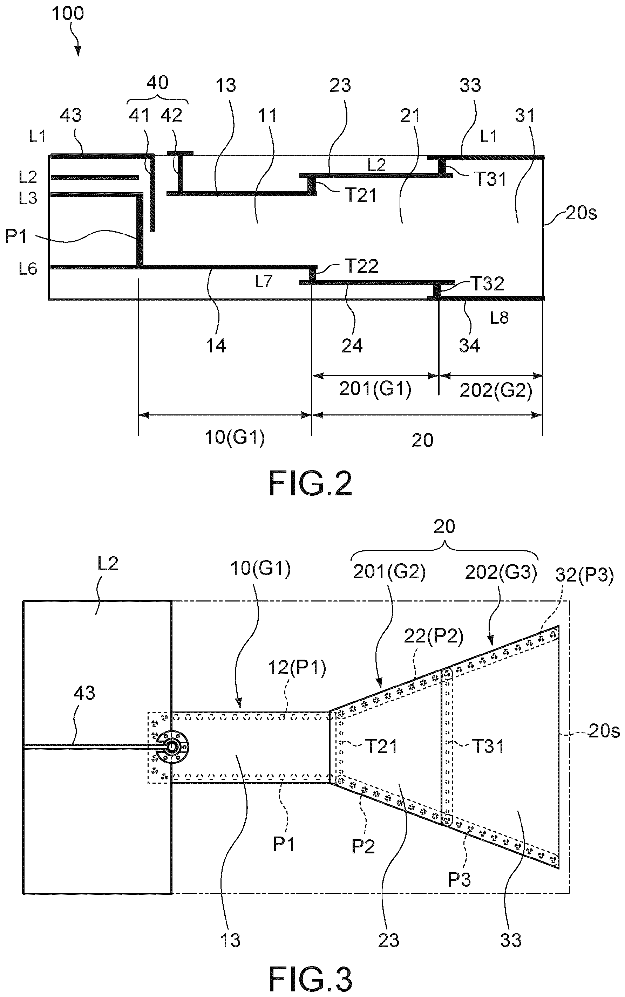

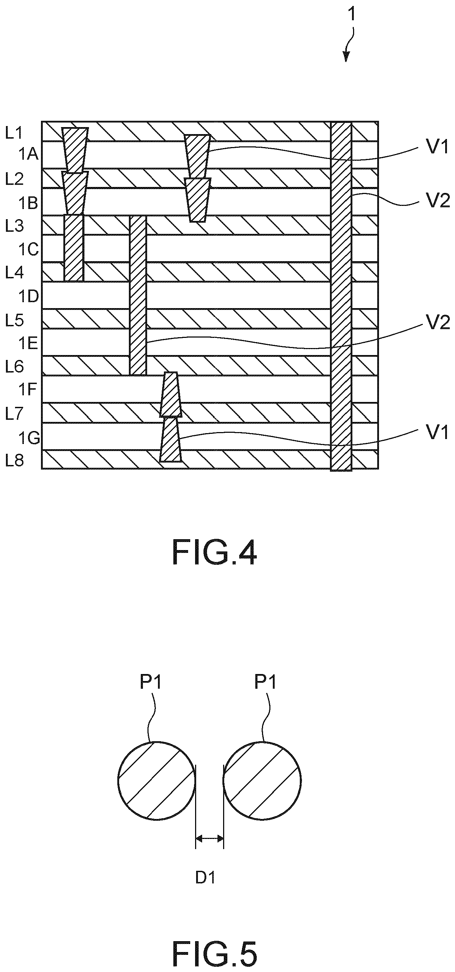

Fig. 1 is a partially transparent perspective view showing a horn antenna 100 according to a first embodiment of the present technology, Fig. 2 is a cross-sectional view taken along the line A-A in Fig. 1, Fig. 3 is a plan view of the horn antenna 100, and Fig. 4 is a cross-sectional side view schematically showing a dielectric multilayer substrate 1 constituting the horn antenna 100.

Note that in the drawings, an X-axis, a Y-axis, and a Z-axis indicate three axial directions orthogonal to each other and respectively correspond to the width direction, the length direction, and the thickness direction of the horn antenna 100.

### [Horn antenna]

The horn antenna 100 according to this embodiment includes a waveguide portion 10, a horn portion 20, and a power supply unit 40. The horn antenna 100 may configured as an antenna for transmission, may be configured as an antenna for reception, or may be configured as an antenna for transmission and reception. Here, a case where the horn antenna 100 is configured as an antenna for transmission will be described as an example.

The horn antenna 100 is provided inside the dielectric multilayer substrate 1 having a thickness direction in the Z-axis direction. First, the dielectric multilayer substrate 1 will be described.

### (Dielectric multilayer substrate)

As shown in Fig. 4, the dielectric multilayer substrate 1 includes a plurality of (seven in this example) dielectric layers 1A to 1G from the top and a plurality of (eight in this example) wiring layers L1 to L8 individually disposed between the respective layers of the dielectric layers 1A to 1G.

Each of the dielectric layers 1A to 1G is formed of, for example, an insulating organic material such as an epoxy resin and a fluorine resin such as polytetrafluoroethylene, or an insulating inorganic material such as ceramics. The dielectric constant of each of the dielectric layers 1A to 1G can be arbitrarily set in accordance with the frequency of a radio wave transmitted or received by the horn antenna 10. For example, for transmission/reception applications of radio waves (millimeter waves) in the 60 GHz band, a material having a dielectric constant of, for example, 3.6 is used for each of the dielectric layers 1A to 1G.

The thickness of each of the dielectric layers 1A to 1G can also be arbitrarily set. For example, for the dielectric layer 1C and the dielectric layer 1E, a core material thicker than those of the other dielectric layers 1A, 1B, 1D, 1F, and 1G may be used. As a result, the rigidity of the dielectric multilayer substrate 1 can be increased. In this case, for the dielectric layer 1D disposed between the dielectric layers 1C and 1E, a prepreg material that bonds these dielectric layers 1C and 1E to each other can be used. Further, similarly, a prepreg material can be applied also to the dielectric layers 1A, 1B, 1F, and 1G. In this case, the dielectric layers 1A, 1B, 1F, and 1G are sequentially stacked on the core material described above by a build-up method.

When the dielectric constant of each of the dielectric layers 1A to 1G is set to 3.6, the wavelength of a radio wave with a frequency of 60 GHz is approximately 2.64 mm. In this case, the thickness of each of the dielectric layers 1A, 1B, 1F, and 1G, the thickness of the dielectric layer 1C, the thickness of the dielectric layer 1D, and the thickness of the dielectric layer 1E can be respectively set to approximately 80um, approximately 750 µm, approximately 110 µm, and approximately 200 µm.

Each of the wiring layers L1 to L8 is typically formed of a metal material. In this embodiment, a copper foil having a predetermined thickness is used. Each of the wiring layers L1 to L8 is patterned into a predetermined shape. Therefore, the upper and lower dielectric layers are directly stacked without a wiring layer in a circuit non-formation region in which no wire is present.

The wiring layers L1 to L8 are electrically connected to each other at arbitrary positions. As an interlayer connection portion for connecting between the wiring layers L1 to L8, a form of connecting adjacent two wiring layers to each other(through hole V1 in Fig. 4) and a form of commonly connecting three or more wiring layers to each other (through hole V2 in Fig. 4) can be applied. The through holes V1 and V2 may each include a metal pillar filled with a conductor, such as a metal plug and metal plating.

Subsequently, details of the respective portions of the horn antenna 100 will be described with reference to Fig. 1 to Fig. 3.

### (Waveguide portion)

The waveguide portion 10 includes a first dielectric block 11, a first post wall 12, and two conductor layers 13 and 14.

The first dielectric block 11 is formed in a substantially rectangular parallelepiped shape. The first dielectric block 11 is a stacked body of the dielectric layers 1C, 1D, and 1E on the inner layer side of the dielectric multilayer substrate 1 shown in Fig. 4 and is a layer including only a dielectric in which the wiring layers L4 and L5 are not present on the interfaces of these dielectric layers 1C to 1E.

The first post wall 12 includes a plurality of conductive columnar bodies P1 (first conductive columnar bodies) passing through the first dielectric block 11, and demarcates a first waveguide G1 extending in one axial direction (Y-axis direction) in the first dielectric block 11. The first waveguide G1 is a dielectric waveguide that forms a transmission path for radio waves (millimeter waves). The conductive columnar bodies P1 form both side walls of the first waveguide G1 and a rear wall on the side opposite to the horn portion 20.

Each of the conductive columnar bodies P1 is a columnar body formed of a metal and connects between the two first conductor layers 13 and 14 facing each other across the first dielectric block 11 in the thickness direction (Z-axis direction). One first conductor layer 13 corresponds to the wiring layer L3 in Fig. 4, and the other first conductor layer 14 corresponds to the wiring layer L6 in Fig. 4. The first conductor layers 13 and 14 face each other with an interval (first interval) corresponding to the total thickness of the dielectric layers 1C to 1E. The first conductor layers 13 and 14 are each formed in a rectangular shape having long sides in the Y-axis direction, respectively demarcate the top surface and the bottom surface of the first waveguide G1, and are typically connected to a ground potential.

The conductive columnar bodies P1 are arrayed along the long sides of the first conductor layers 13 and 14 and the short side on the side opposite to the horn portion 20. In order to confine radio waves in the first waveguide G1 by the first post wall 12, the conductive columnar bodies P1 are arrayed with a gap D1 of a predetermined value or less as shown in Fig. 5. When the wavelength of a radio wave propagating through the dielectric (first waveguide G1) is defined as λ, the gap D1 is favorably equal to or less than one-fourth (0.25λ (0.66 mm)) of the wavelength A.

### (Horn portion)

The horn portion 20 includes is connected to one end of the waveguide portion 10 in the one axial direction described above. In this embodiment, the horn portion 20 includes a first widening portion 201 and a second widening portion 202.

The first widening portion 201 includes a second dielectric block 21, a second post wall 22, and two conductor layers 23 and 24.

The second dielectric block 21 is formed in a trapezoidal cube thicker than the first dielectric block 11. The second dielectric block 21 is a stacked body of the dielectric layers 1B, 1C, 1D, 1E, and 1F on the inner layer side of the dielectric multilayer substrate 1 shown in Fig. 4 and is a layer including only a dielectric in which the wiring layers L3 to L6 are not present on the interfaces of these dielectric layers 1B to 1F.

The second post wall 22 includes a plurality of conductive columnar bodies P2 (second conductive columnar bodies) passing through the second dielectric block 21 and demarcates a second waveguide G2 whose width increases as a distance from the first waveguide G1 increases in the second dielectric block 21. The second waveguide G2 is a dielectric waveguide that forms a transmission path for radio waves. The conductive columnar bodies P2 form both side walls of the second waveguide G2.

Each of the conductive columnar bodies P2 is a columnar body formed of a metal and connects between the two second conductor layers 23 and 24 facing each other across the second dielectric block 21 in the thickness direction (Z-axis direction). One second conductor layer 23 corresponds to the wiring layer L2 in Fig. 4, and the other second conductor layer 24 corresponds to the wiring layer L7 in Fig. 4. The second conductor layers 23 and 24 face each other with an interval corresponding to the total thickness of the dielectric layers 1B to 1F. The second conductor layers 23 and 24 are each formed in a trapezoidal shape having one bottom surface on the side of the first waveguide G1, respectively demarcate the top surface and the bottom surface of the second waveguide G2, and are typically connected to a ground potential.

Note that the conductive columnar bodies P2 constituting the second post wall 22 may each include a columnar body having the same height as those of the conductive columnar bodies P1 constituting the first post wall 12, and the upper and lower end portions of the conductive columnar bodies P2 may be electrically connected to the second conductor layers 23 and 24 via interlayer connection portions. Alternatively, the conductive columnar bodies P2 may each include a columnar body having a height corresponding to the facing distance between the second conductor layers 23 and 24.

The second conductor layer 23 is electrically connected to the first conductor layer 13 via a plurality of interlayer connection portions T21. Similarly, the second conductor layer 24 is electrically connected to the first conductor layer 14 via a plurality of interlayer connection portions T22. The interlayer connection portion T21 is a through hole passing through the dielectric layer 1B, and the interlayer connection portion T22 is a through hole passing through the dielectric layer 1F. The interlayer connection portions T21 and T22 are respectively arrayed along the bases of the second conductor layers 23 and 24 on the side of the waveguide portion 10.

The conductive columnar bodies P2 are linearly arrayed along two oblique sides of the second conductor layers 23 and 24, but are not limited thereto and may be arrayed in a curved line like a trumpet shape. The inclination angle of the oblique side described above from the Y-axis direction is not particularly limited, and is, for example, 10° to 70°.

In order to confine radio waves in the second waveguide G2 by the second post wall 22, the conductive columnar bodies P2 are arrayed with a gap equal to or less than one-fourth (0.66 mm) of the wavelength of a radio wave propagating through the second waveguide G2. Similarly, the interlayer connection portions T21 and T22 are also arrayed with a gap of 0.66 mm of less.

Meanwhile, the second widening portion 202 includes a third dielectric block 31, a third post wall 32, and two conductor layers 33 and 34.

The third dielectric block 31 is formed in a trapezoidal cube thicker than the second dielectric block 21. The third dielectric block 31 is a stacked body of the dielectric layers 1A, 1B, 1C, 1D, 1E, 1F, and 1G in the dielectric multilayer substrate 1 shown in Fig. 4 and is a layer including only a dielectric in which the wiring layers L2 to L7 are not present on the interfaces of these dielectric layers 1A to 1G.

The third post wall 32 includes a plurality of conductive columnar bodies P3 (third conductive columnar bodies) passing through the third dielectric block 31 and demarcates a third waveguide G3 whose width increases as a distance from the second waveguide G2 increases in the third dielectric block 31. The third waveguide G3 is a dielectric waveguide that forms a transmission path for radio waves. The conductive columnar bodies P3 form both side walls of the third waveguide G3.

Each of the conductive columnar bodies P3 is a columnar body formed of a metal and connects between the two second conductor layers 33 and 34 facing each other across the third dielectric block 31 in the thickness direction (Z-axis direction). One third conductor layer 33 corresponds to the wiring layer L1 in Fig. 4, and the other third conductor layer 34 corresponds to the wiring layer L8 in Fig. 4. The third conductor layers 33 and 34 are each formed in a trapezoidal shape having one bottom surface on the side of the second waveguide G2, respectively demarcate the top surface and the bottom surface of the third waveguide G3, and are typically connected to a ground potential.

Note that the conductive columnar bodies P3 constituting the third post wall 32 may each include a columnar body having the same height as those of the conductive columnar bodies P1 constituting the first post wall 12, and the upper and lower end portions of the conductive columnar bodies P3 may be electrically connected to the third conductor layers 33 and 34 via interlayer connection portions. Alternatively, the conductive columnar bodies P3 may each include a columnar body having a height corresponding to the facing distance between the third conductor layers 33 and 34.

The third conductor layer 33 is electrically connected to the second conductor layer 23 via a plurality of interlayer connection portions T31. Similarly, the third conductor layer 34 is electrically connected to the second conductor layer 24 via a plurality of interlayer connection portions T32. The interlayer connection portion T31 is a through hole passing through the dielectric layer 1A, and the interlayer connection portion T32 is a through hole passing through the dielectric layer 1G. The interlayer connection portions T31 and T32 are respectively arrayed along the bases of the third conductor layers 33 and 34 on the side of the first widening portion 201.

The conductive columnar bodies P3 are linearly arrayed along two oblique sides of the third conductor layers 33 and 34. In this embodiment, as shown in Fig. 3, the third post wall 32 is disposed on the same straight line as the second post wall 22. In order to confine radio waves in the third waveguide G2 by the third post wall 32, the conductive columnar bodies P3 are arrayed with a gap equal to or less than one-fourth (0.66 mm) of a wavelength of a radio wave propagating through the third waveguide G3. Similarly, the interlayer connection portions T31 and T32 are also arrayed with a gap of 0.66 mm or less.

The tip portion of the horn portion 20 in the Y-axis direction forms an antenna opening 20s for radiating radio waves. This antenna opening 20s may be in contact with the air surface, or may be covered with the dielectric layer of the dielectric multilayer substrate 1. As a result, it is possible to reduce the radiation loss of radio waves from the third waveguide G3 to the atmosphere, thereby improving the antenna gain. The length of the dielectric layer from the antenna opening 20s to the air surface is favorably equal to or greater than one-fourth of a wavelength of a radio wave propagating through the third waveguide G3.

The sizes of the respective portions of the horn antenna 100 are not particularly limited. For example, the distance from a feeding probe 41 to the horn portion 20 along the Y-axis direction is 5 mm, the length of the horn portion 20 in the Y-axis direction is 8 mm, and the length of the tip (antenna opening 20s) of the horn portion 20 along the X-axis direction is 8 mm.

Note that the horn portion 20 is not necessarily need to include the first widening portion 201 and the second widening portion 202, and may include only the first widening portion 201. The same applies also to the following embodiments.

### (Power supply unit)

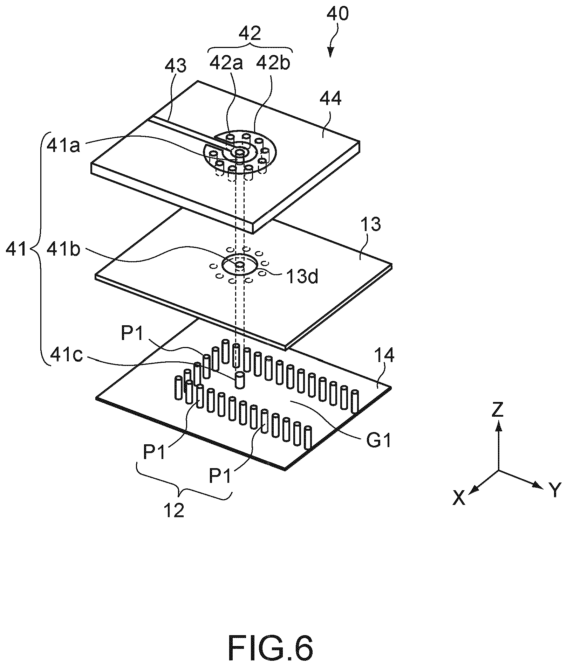

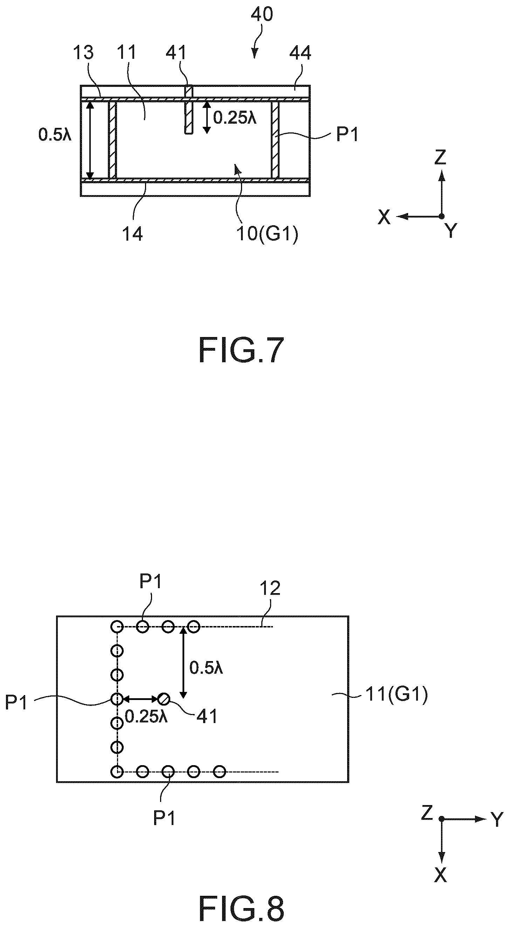

Subsequently, the power supply unit 40 will be described. Fig. 6 is a partially exploded perspective view showing the layer structure of the power supply unit 40, Fig. 7 is a front cross-sectional view of a main part of the power supply unit 40, and Fig. 8 is a schematic plan view of a main part of the power supply unit 40.

The power supply unit 40 includes a microstrip line to be connected to the waveguide portion 10. The power supply unit 40 functions as a conversion unit that converts a millimeter-wave signal, which is introduced from a signal processing circuit (not shown) via a signal line 43, into a waveguide mode in the first waveguide G1.

The power supply unit 40 includes the feeding probe 41 that supplies a millimeter-wave signal to the first waveguide G1, and a shield portion 42 formed around the feeding probe 31.

The feeding probe 41 is a conductor to be inserted into the vicinity of the rear wall of the first waveguide G1 in the Z-axis direction, and includes a base end portion 41a, an intermediate portion 41b, and a tip portion 41c.

The base end portion 41a of the feeding probe 41 is a through hole passing through an insulation layer 44 forming the top surface portion of the waveguide portion 10. The base end portion 41a is connected to a signal processing circuit (not shown) via the signal line 43 extending in the Y-axis direction on the insulation layer 44. The base end portion 41a and the signal line 43 are formed by part of the wiring layer L1 of the multilayer wiring substrate 1 shown in Fig. 4. The insulation layer 44 is a stacked body of the dielectric layers 1A and 1B and is a layer including only a dielectric in which the wiring layers L are not present on the interfaces of these dielectric layers 1A and 1B.

Note that the signal line 43 forms a microstrip line facing the wiring layer L2 across the dielectric layer 1A. The wiring layer L2 is connected to a ground potential. The line width of the signal line 43 is arbitrarily set in accordance with the frequency of a millimeter-wave signal to be introduced into the power supply unit 41 and the dielectric constant of the dielectric layer. For example, in the case where the frequency of a millimeter-wave signal is 60 GHz and the dielectric constant of the dielectric layer is 3.6, the line width of the signal line 43 is, for example, approximately 0.11 mm. By forming the signal line 43 by the outermost wiring layer of the multilayer wiring substrate 1, the signal line 43 having such a fine line width can be stably formed.

The intermediate portion 41b of the feeding probe 41 is formed by part of the first conductor layer 13. The intermediate portion 41b is electrically insulated from the first conductor layer 13 by being provided in a partial insulating layer 13d formed by filling an opening locally provided at a predetermined position of the first conductor layer 13 with an insulating material. The intermediate portion 41b is connected to the base end portion 41a.

The tip portion 41c of the feeding probe 41 is provided on the first dielectric block 11 forming the first waveguide G1. The feeding probe 41 is formed to have a length smaller than the thickness of the first dielectric block 11. In this embodiment, as shown in Fig. 7, the feeding probe 41 is formed to have a length of, for example, 0.25λ (0.66 mm) from the first conductor layer 13 to the second conductor layer 14 when the thickness of the first dielectric block 11 is 0.5λ.

The feeding probe 41 includes a columnar body plated with a metal such as copper plating. In the feeding probe 41, the base end portion 41a, the intermediate portion 41b, and the tip portion 41c are integrated with each other in the process of sequentially building up the dielectric layer 1B and the dielectric layer 1A on the wiring layer L3 in the dielectric multilayer substrate 1 shown in Fig. 4. As shown in Fig. 8, when the center-to-center distance along the X-axis direction of the conductive columnar bodies P1 forming both side walls of the first post wall 12 is defined as 1λ, the feeding probe 41 is disposed at a position 0.5λ, away from both side walls of the first post wall 12 and 0.25λ, away from the rear wall of the first post wall 12.

Meanwhile, as shown in Fig. 6, the shield portion 42 includes a plurality of columnar portions 42a arranged around the power supply unit 41, and a base layer 42b having an arc shape, which commonly supports the columnar portions 42a. The base layer 42b is formed by part of the conductor layer (wiring layer L1) formed on the surface of the insulation layer 44, and electrically insulated from the feeding probe 41 and the signal line 43. The columnar portions 42a are through holes that are electrically connected to the base layer 42b, pass through the insulation layer 44, and are electrically connected to the first conductor layer 13 (first conductor layer 13 around the partial insulating layer 13d).

### [Antenna characteristics]

In the horn antenna 10 according to this embodiment configured as described above, a millimeter-wave signal supplied to the waveguide portion 10 via the power supply unit 40 propagates toward the horn portion 20 via the first waveguide G1. The waveguide portion 10 functions as a filter that determines the frequency band of radio waves propagating through the first waveguide G1. The length of the waveguide portion 10 is not particularly limited, and can be arbitrarily set in accordance with desired band characteristics.

The horn portion 20 causes the radio waves transmitted from the waveguide portion 10 to propagate toward the antenna opening 20s while spreading the radio waves in the width direction (X-axis direction) and the height direction (Z-axis direction). The length of the horn portion 20 along the Y-axis direction is not particularly limited. As the length becomes longer, it is possible to increase the directivity of the radio waves radiated from the antenna opening 20s.

Further, in accordance with this embodiment, the thicknesses of the second waveguide G2 and the third waveguide G3 constituting the horn portion 20 are increased in a stepwise manner by the first widening portion 201 and the second widening portion 202, respectively. Therefore, since the horn portion 20 has an opening angle in the height direction thereof, the area of the antenna opening 20s increases as compared with the case where the horn portion 20 is formed to have the same thickness as that of the waveguide portion 10, thereby improving the antenna gain.

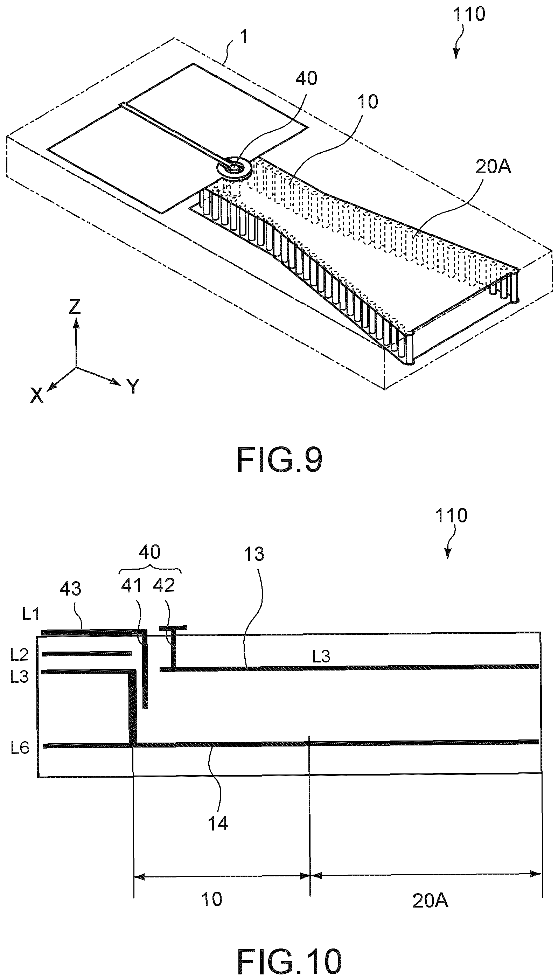

Fig. 9 and Fig. 10 are respectively a schematic perspective view of an entire horn antenna 110 according to a Comparative Example and a cross-sectional side view of the central portion thereof in the width direction (X-axis direction). In the horn antenna 110 according to the Comparative Example, a horn portion 20A is different from the horn portion 20 of the horn antenna 10 according to this embodiment in that the entire horn portion 20A is formed to have the same thickness as that of the waveguide portion 10. That is, in the Comparative Example, the conductor layers forming the top surface and the bottom surface of the horn portion 20A are respectively formed by the conductor layers 13 and 14 forming the top surface and the bottom surface of the waveguide portion 10.

Note that portions corresponding to those of the horn antenna 10 according to this embodiment are denoted by the same reference symbols. Further, in the Comparative Example, the configurations other than the horn portion 20A are the same as those of the above-mentioned horn antenna 10 according to this embodiment.

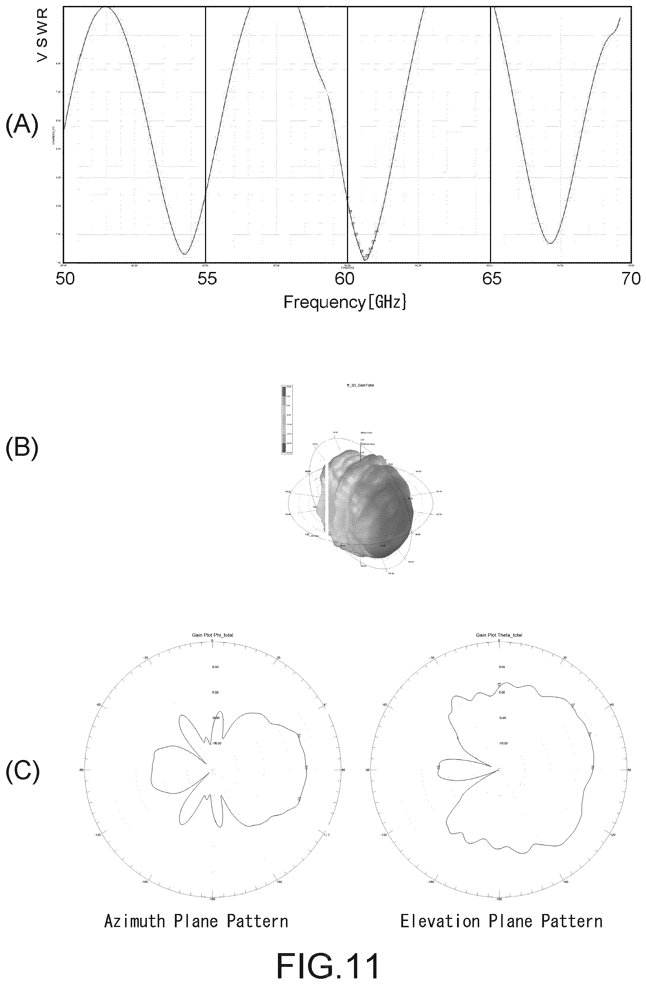

Fig. 11 is a simulation result showing radiation characteristics of the horn antenna 110 according to the Comparative Example, Part (A) shows a voltage standing wave ratio (VSWR), Part (B) shows a three-dimensional radiation pattern, the left side of Part (C) shows an azimuth plane (XY plane) pattern, and the right side thereof shows an elevation plane (YZ plane) pattern. Note that Parts (B) and (C) show radiation patterns at 60.5 GHz.

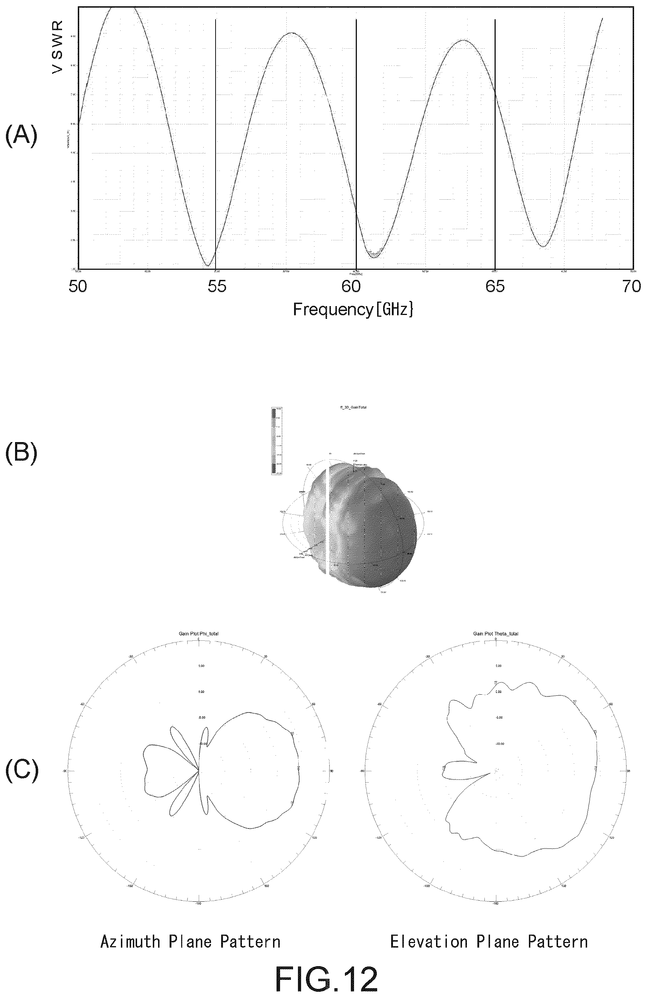

Meanwhile, Fig. 12 is a simulation result showing radiation characteristics of the horn antenna 100 according to this embodiment, Part (A) shows a voltage standing wave ratio (VSWR), Part (B) shows a three-dimensional radiation pattern, the left side of Part (C) shows an azimuth plane pattern, and the right side thereof shows an elevation plane pattern. Parts (B) and (C) show radiation patterns at 60.5 GHz.

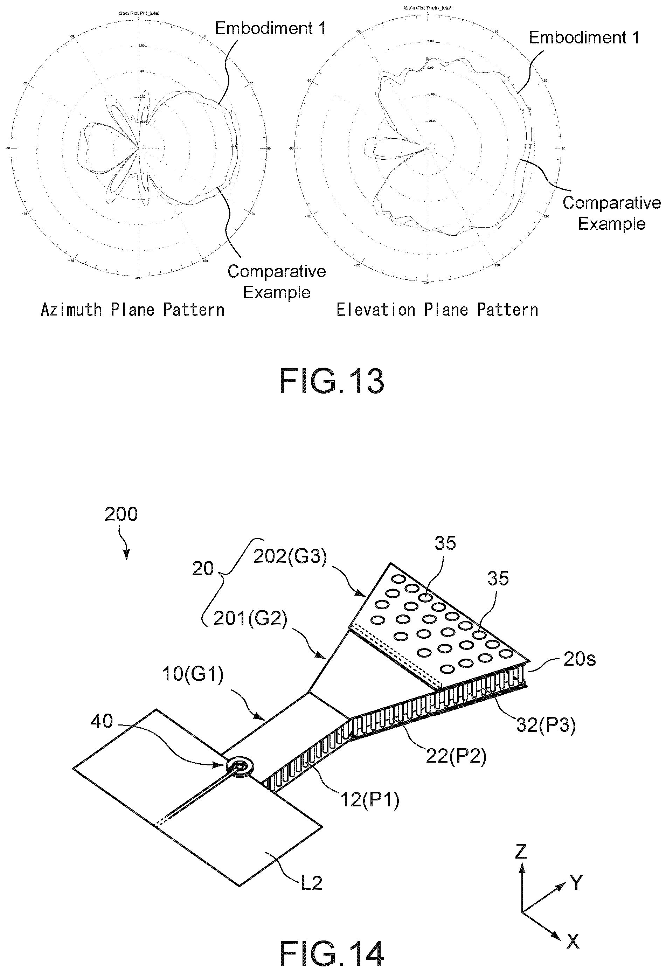

Further, Fig. 13 is a diagram showing radiation patterns of the horn antenna 100 according to this embodiment (embodiment 1) and the horn antenna 110 according to the Comparative Example in comparison with each other.

As shown in Part (A) of Fig. 11 and Part (A) of Fig. 12, in accordance with the horn antenna 100 according to this embodiment, the peak width of the resonance point near 60.5 GHz is wider than that in the Comparative Example, and therefore, frequency characteristics in a wider frequency band than that in the Comparative Example can be achieved. Further, as shown in Fig. 13, in accordance with this embodiment, the directivity of the main lobe is higher (the back lobe and the side lobe are lower) than that in the Comparative Example, and therefore, it is possible to improve the antenna gain.

### <Second embodiment>

Fig. 14 is a partially transparent perspective view showing a horn antenna 200 according to a second embodiment of the present technology. Note that illustration of the dielectric multilayer substrate 1 is omitted.

Hereinafter, configurations different from those in the first embodiment will be mainly described, configurations similar to those in the first embodiment will be denoted by similar reference symbols, and description thereof is omitted or simplified.

Forming a horn antenna in a dielectric multilayer substrate tends to reduce, when radio waves are emitted from the horn antenna, the radiation efficiency of the antenna due to the impedance mismatch between the dielectric forming the substrate and space. Since a decrease in radiation efficiency results in a decrease in antenna gain, it is necessary to minimize the decrease in radiation efficiency.

In this regard, in the horn antenna 200 according to this embodiment, a plurality of air hole portions 35 is provided in the second widening portion 202 of the horn portion 20. The air hole portion 35 is a through hole passing through the formation region of the third dielectric block 31 and the third conductor layers 33 and 34 (see Fig. 2) constituting the third waveguide G3 in the Z-axis direction, and the inside thereof is air in communication with the outside air. The air hole portion 35 is typically cylindrical. However, it goes without saying that the shape of the air hole portion 35 is not limited thereto, and may be oval, rectangular, or another cylindrical shape, for example.

The opening width (diameter) of the air hole portion 35 is smaller than a wavelength λ of a radio wave propagating through the third dielectric 31 and is favorably λ/4 (0.66 mm in this example) or less. As a result, it is possible to prevent radio waves from leaking from the air hole portion 35.

By adjusting the dielectric constant of the third waveguide G3 that is the final waveguide of the horn antenna 200 to a value between the dielectric constant of the third dielectric 31 (e.g., 3.6) and the dielectric constant of air (1.0), the impedance mismatch between the inside of the horn antenna 200 and space is alleviated. It is favorable to distribute the air hole portions 35 in the horn portion 20 such that the number or formation density of the air hole portions 35 increases as closer to the antenna opening 20s. This facilitates the impedance matching between the third dielectric 31 and air, thereby reducing the radiation loss of radio waves from the antenna opening 20s. As a result, it is possible to improve the antenna gain as compared with the case where the air hole portion 35 are not provided.

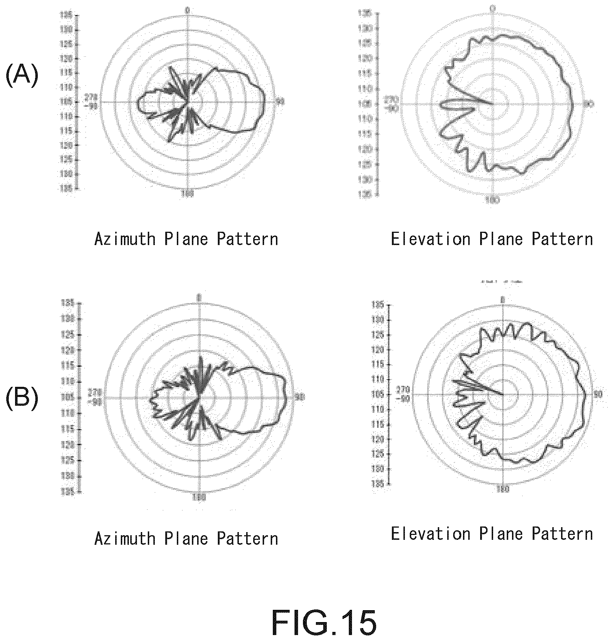

As an example, Fig. 15 shows the difference in radiation characteristics with or without the air hole portion 35. Part (A) is a simulation result showing radiation characteristics of a horn antenna that does not include the air hole portion 35 (corresponding to the first embodiment), the left side shows an azimuth plane pattern, and the right side shows an elevation plane pattern. Meanwhile, Part (B) of Fig. 15 is a similar simulation result showing radiation characteristics of the horn antenna 200 according to this embodiment that includes the air hole portion 35.

As shown in Parts (A) and (B) of Fig. 15, in accordance with this embodiment, the directivity of the main lobe is higher than that in the case where the air hole portion 35 is not provided, and therefore, it is possible to improve the gain.

### <Third embodiment>

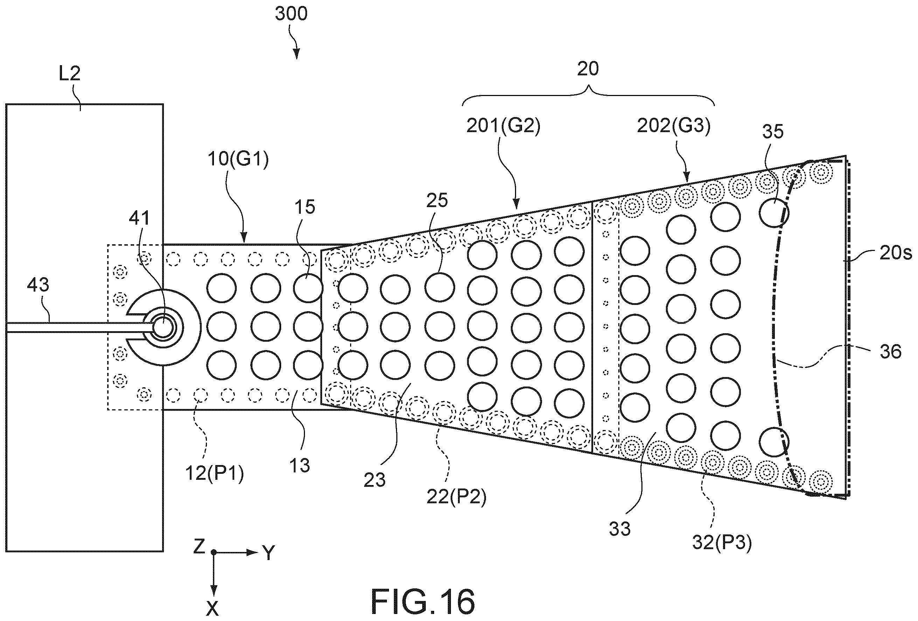

Fig. 16 is a schematic plan view showing a horn antenna 300 according to a third embodiment of the present technology. Note that illustration of the dielectric multilayer substrate 1 is omitted.

Hereinafter, configurations different from those in the first and second embodiments will be mainly described, configurations similar to those in the first and second embodiments will be denoted by similar reference symbols, and description thereof is omitted or simplified.

While the air hole portions 35 are formed in the second widening portion 202 of the horn portion 20 in the above-mentioned second embodiment, this embodiment is different from the second embodiment in that similar air hole portions 15 and 25 are respectively formed in the waveguide portion 10 and the first widening portion 201 of the horn portion 20. The opening width (diameter) of each of the air hole portions 15 and 25 is set similarly to the opening width (diameter) of the air hole portion 35.

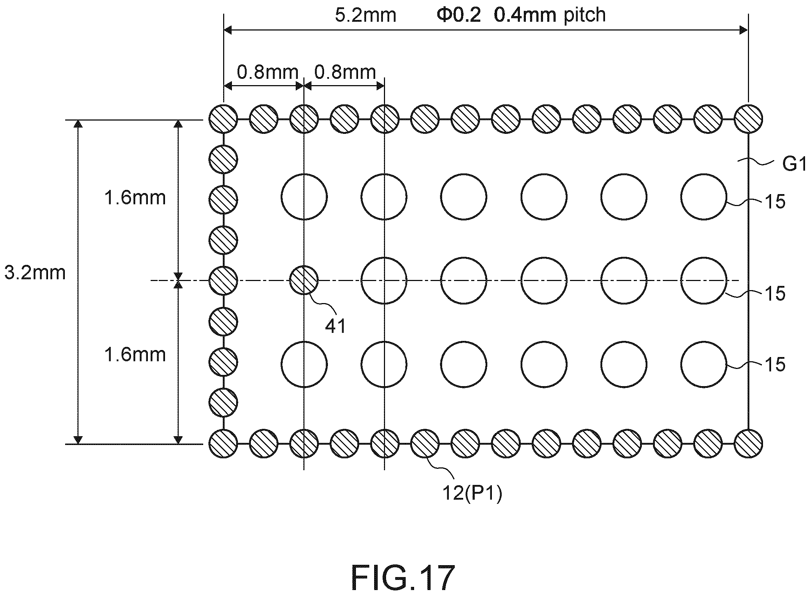

The air hole portion 15 provided in the waveguide portion 10 (the first waveguide G1) is a cylindrical through hole passing through the formation region of the first dielectric block 11 and the first conductor layers 13 and 14 (see Fig. 2) in the Z-axis direction, and the inside thereof is air in communication with the outside air. By forming the plurality of air hole portions 15 in the waveguide portion 10, the dielectric constant of the first waveguide G1 can be made smaller than the dielectric constant of the first dielectric block 11. The array number and array form of the air hole portions 15 can be arbitrarily set in accordance with the intended dielectric constant of the first waveguide G1. As an example, the array form of the air hole portions 15 is shown in Fig. 17.

As shown in Fig. 17, the long side of the first waveguide G1 is set to 5.2 mm, and the short side thereof is set to 3.2 mm. In this regard, as shown in the figure, a case where the diameter of the air hole portion 15 is set to 0.4 mm and the array pitch is set to 0.8 mm pitch to form a total of 17 air hole portions 15 is considered.

In this case, the area of each of the air hole portions 15 is 0.1256 mm² (n × 0.2 mm²), and the occupation ratio of the total area of the air hole portions 15 (0.1256 mm² × 17 = 2.1352 mm²) to the area of the first waveguide P1 (5.2 mm × 3.2 mm = 16.64 mm²) is 12.83%. As a result, the dielectric constant of the first waveguide G1 is 12.83% lower than the dielectric constant of the first dielectric block 11 (3.6), i.e., approximately 3.14.

Note that the diameter of each of the conductive columnar bodies P1 constituting the first post wall 12 or the gap therebetween is set to, for example, equal to or less than one-fourth of a wavelength of a radio wave propagating through the first waveguide G1 including the air hole portions 15. Here, the diameter of each of the conductive columnar bodies P1 was set to 0.2 mm and the array pitch thereof was set to 0.4 mm.

The air hole portions 25 and 35 provided in the horn portion 20 (the second waveguide G2 and the third waveguide G3) can also be formed in the same manner as that for the above-mentioned air hole portion 15. As a result, since the dielectric constants of the waveguides G1 to G3 of the horn antenna 300 can be made closer to the dielectric constant of the air, the impedance mismatch with air is further alleviated and the radiation loss in the antenna opening 20s can be further reduced.

The air hole portions 35 provided in the second widening portion 202 (the third waveguide G3) of the horn portion 20 may include a dielectric lens portion 36 formed by part of the plurality of air hole portions 35 at one end in the Y-axis direction, i.e., one end portion on the side of the antenna opening 20s. This dielectric lens portion 36 includes a curved surface portion having a shape projecting from the antenna opening 20s toward the side of the waveguide portion 10. As a result, the dielectric lens portion 36 functions as a convergent lens for converging, in the Y-axis direction, radio waves travelling from the horn portion 20 toward the antenna opening 20s, thereby further enhancing the directivity of the radio waves to the front direction.

Note that the present technology is not limited thereto, and the air hole portions 35 provided in the second widening portion 202 (the third waveguide G3) of the horn portion 20 may be configured in the same manner as that in the second embodiment.

### <Fourth embodiment>

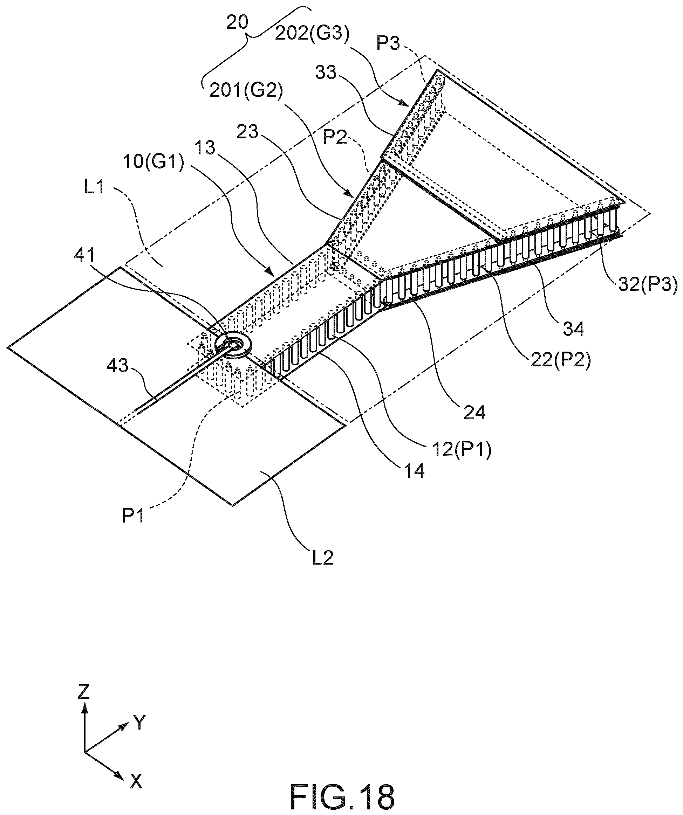

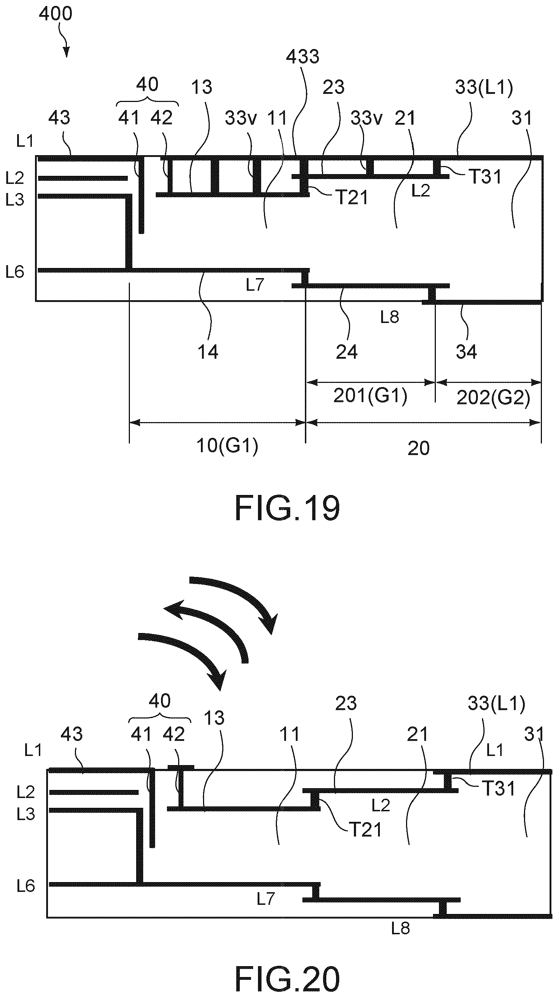

Fig. 18 is a schematic perspective view showing a horn antenna 400 according to a fourth embodiment of the present technology (illustration of the dielectric multilayer substrate 1 is omitted), and Fig. 19 is a schematic cross-sectional side view of the central portion thereof in the width direction (X-axis direction).

Hereinafter, configurations different from those in the first embodiment will be mainly described, configurations similar to those in the first embodiment will be denoted by similar reference symbols, and description thereof is omitted or simplified.

As described above, when the frequency of a millimeter-wave signal to be introduced into the power supply unit 40 reaches the 60 GHz band, the signal line 43 has a microstrip line structure. That is, the signal line 43 creates an electric field between the signal line 43 and the wiring layer L2 connected to the ground potential immediately therebelow to transmit a highfrequency signal. This electric field component couples the transmission line of the power supply unit 40 and the horn antenna. As a result, as shown in Fig. 20, radio waves are emitted from these first to third conductor layers 13, 23, and 33 (the wiring layers L1, L2, and L3), which deteriorates the antenna characteristics in some cases.

In order to solve such a problem, as shown in Fig. 19, the horn antenna 400 according to this embodiment includes a shield layer 433 that covers the first conductor layer 13 and the second conductor layer 23. The shield layer 433 is formed by extending the third conductor layer 33 right above the waveguide portion 10 and the first widening portion 201 of the horn portion 20. The shield layer 433 is electrically connected to the first conductor layer 13 and the second conductor layer 23 via a plurality of through holes 33v. Further, the shield layer 433 includes the wiring layer L1 that is connected to a ground potential and is electrically insulated from the signal line 43.

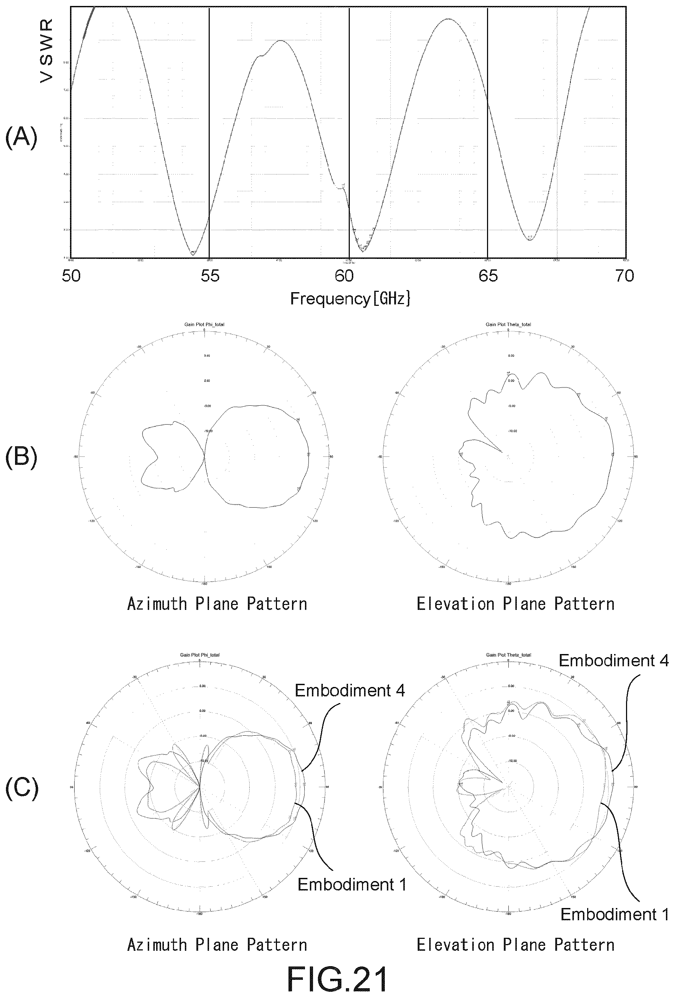

Fig. 21 is a simulation result showing radiation characteristics of the horn antenna 400 according to this embodiment, Part (A) shows a voltage standing wave ratio (VSWR), the left side of Part (B) shows an azimuth plane pattern, the right side thereof shows an elevation plane pattern, and Part (C) is a diagram showing radiation patterns of the horn antenna 400 according to this embodiment (embodiment 4) and the horn antenna 100 according to the above-mentioned first embodiment (embodiment 1) in comparison with each other. Note that Parts (B) and (C) show radiation patterns at 60.5 GHz.

As shown in Part (A) of Fig. 21, in accordance with the horn antenna 400 according to this embodiment, the resonance point was near 60.5 GHz and the width of the band was not significantly different from that in the embodiment 1 (see Part (A) of Fig. 12).

Meanwhile, as shown in Part (C) of Fig. 21, in accordance with this embodiment, the directivity of the main lobe was higher than that in the first embodiment and the antenna gain was improved. In particular, as shown in the right side of Part (C) of Fig. 21, the radiation to the upper part was reduced and the effect by the shield layer 433 was confirmed.

### <Fifth embodiment>

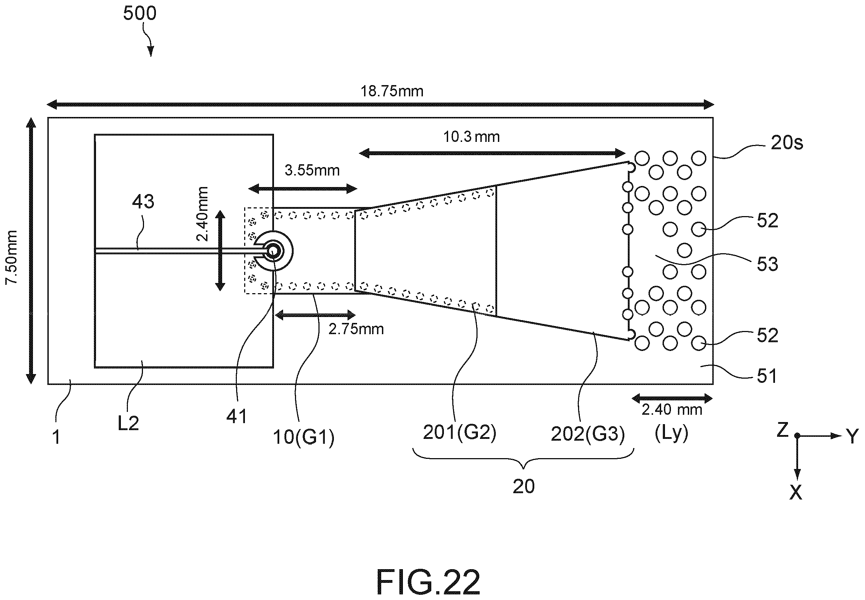

Fig. 22 is a schematic plan view showing a horn antenna 500 according to a fifth embodiment of the present technology. Hereinafter, configurations different from those in the first embodiment will be mainly described, configurations similar to those in the first embodiment will be denoted by similar reference symbols, and description thereof is omitted or simplified.

The horn antenna 500 according to this embodiment is different from that in the above-mentioned first embodiment in that it includes a dielectric portion 51 that covers an opening of the horn portion 20. The dielectric portion 51 is a stacked body of the dielectric layers 1A to 1G in the dielectric multilayer substrate 1 shown in Fig. 4 and is a layer including only a dielectric in which the wiring layers L2 to L7 are not present on the interfaces of these dielectric layers 1A to 1G. The dielectric portion 51 is provided at one end of the horn portion 20 on the side of the antenna opening 20s, and the tip surface of the dielectric portion 51 in the Y-axis direction forms the antenna opening 20s.

A plurality of air hole portions 52 passing through the dielectric portion 51 in the thickness direction (Z-axis direction) is provided in the dielectric portion 51. Each of the air hole portions 52 is for reducing the difference in dielectric constant between the dielectric portion 51 and the air, thereby suppressing the radiation loss of radio waves to be emitted from the antenna opening 20s. The air hole portion 52 is typically cylindrical (approximately 0.4 mm in diameter) and is formed at a predetermined position within the plane of the dielectric portion 51. The opening width (diameter) of the air hole portion 52 is smaller than the wavelength λ of a radio wave propagating through the dielectric portion 51 and is favorably λ/4 (0.66 mm in this example) or less.

In this embodiment, a dielectric lens portion 53 is formed by part of the plurality of air hole portions 52. The dielectric lens portion 53 is formed to have a substantially triangular shape that is a shape projecting from the tip of the horn portion 20 toward the antenna opening 20s in plan view. As a result, the dielectric lens portion 53 functions as a convergent lens for converging, in the Y-axis direction, radio waves travelling from the horn portion 20 toward the antenna opening 20s, thereby further enhancing the directivity of the radio waves to the front direction.

A length Ly of the dielectric portion 51 along the Y-axis direction is typically equal to or greater than one-fourth (λ/4) of a wavelength of a radio wave propagating through the dielectric portion 51 and is the length of approximately one wavelength (2.4 mm) in this embodiment. Note that the sizes of the respective portions of the horn antenna 500 are not particularly limited. In this embodiment, as shown in Fig. 22, the length of the long side of the dielectric portion 1 along the Y-axis direction is 18.75 mm, the length of the short side of the dielectric portion 1 along the X-axis direction is 7.5 mm, the length of the long side of the waveguide portion 10 is 3.55 mm, the length of the short side of the waveguide portion 10 is 2.4 mm, the distance from the feeding probe 41 to the horn portion 20 along the Y-axis direction is 2.75 mm, and the length of the horn portion 20 along the Y-axis direction is 10.3 mm.

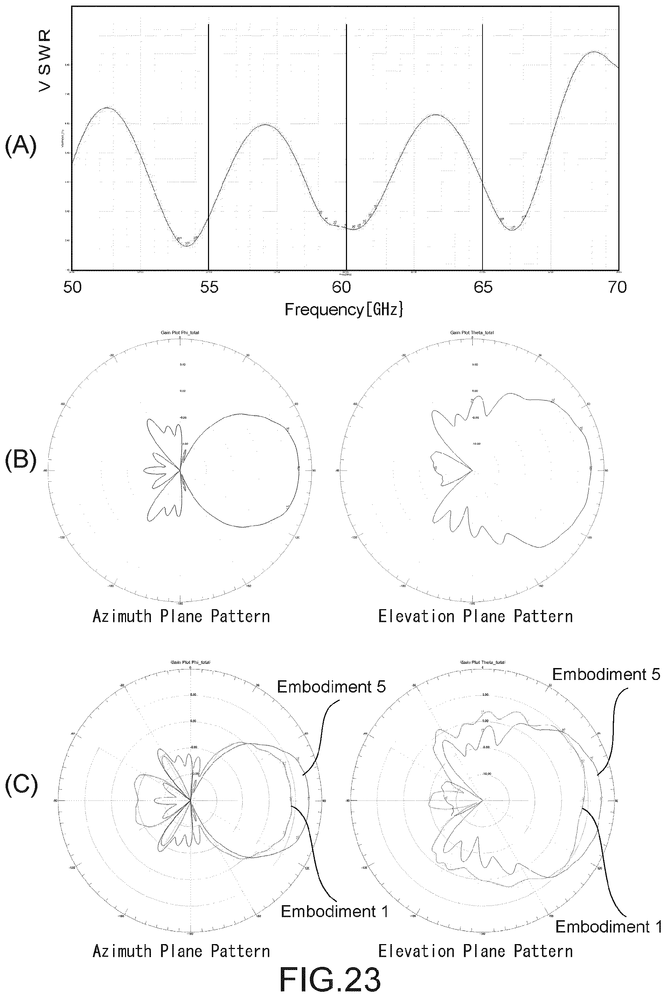

Fig. 23 is a simulation result showing radiation characteristics of the horn antenna 500 according to this embodiment, Part (A) shows a voltage standing wave ratio (VSWR), the left side of Part (B) shows an azimuth plane pattern, the right side thereof shows an elevation plane pattern, and Part (C) is a diagram showing radiation patterns of the horn antenna 500 according to this embodiment (embodiment 5) and the horn antenna 100 according to the above-mentioned first embodiment (embodiment 1) in comparison with each other. Note that Parts (B) and (C) show radiation patterns at 60.5 GHz.

As shown in Part (A) of Fig. 23, in accordance with the horn antenna 500 according to this embodiment, the resonance point was near 60.3 GHz and the band was wider than that in the embodiment 1, but VSWR was deteriorated (see Part (A) of Fig. 12).

Meanwhile, as shown in Part (C) of Fig. 23, in accordance with this embodiment, the directivity of the main lobe was higher than that in the first embodiment and the antenna gain was improved. This is presumed to be the effect achieved by the dielectric lens portion 53.

### <Sixth embodiment>

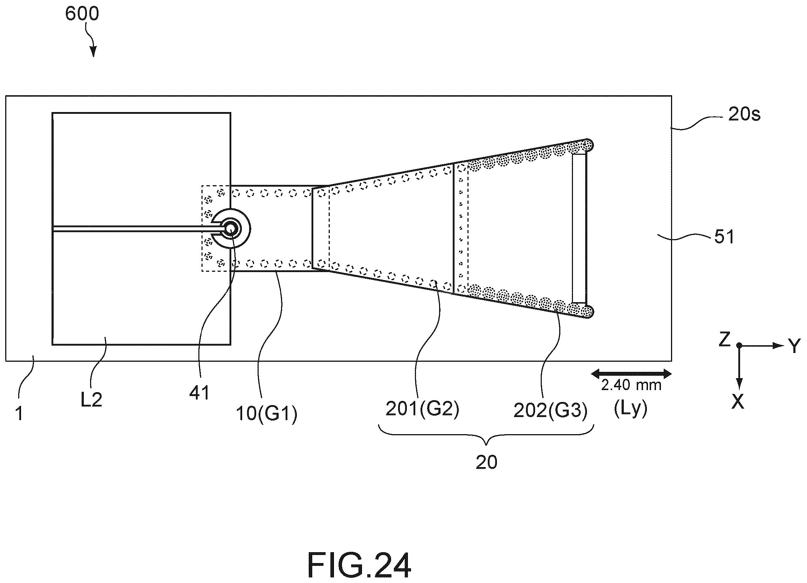

Fig. 24 is a schematic plan view showing a horn antenna 600 according to a sixth embodiment of the present technology. Hereinafter, configurations different from those in the fifth embodiment will be mainly described, configurations similar to those in the fifth embodiment will be denoted by similar reference symbols, and description thereof is omitted or simplified.

The horn antenna 600 according to this embodiment is common to that in the above-mentioned fifth embodiment in that it includes the dielectric portion 51 that covers an opening of the horn portion 20 but is different from that in the fifth embodiment in that it does not include the air hole portion 51. The length Ly of the dielectric portion 51 along the Y-axis direction is 2.4 mm, and the other portions are also formed to have the same sizes as those in the above-mentioned fifth embodiment.

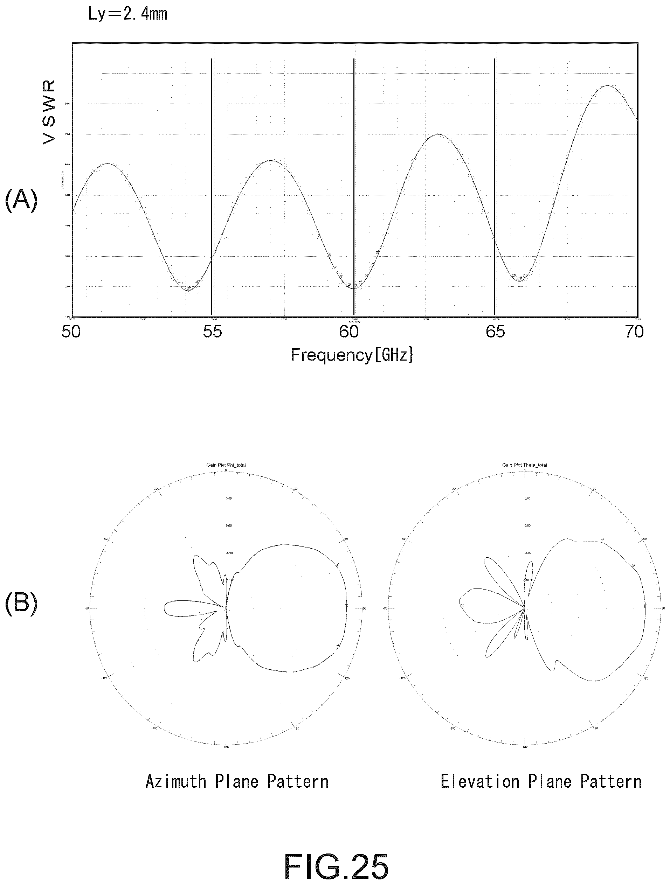

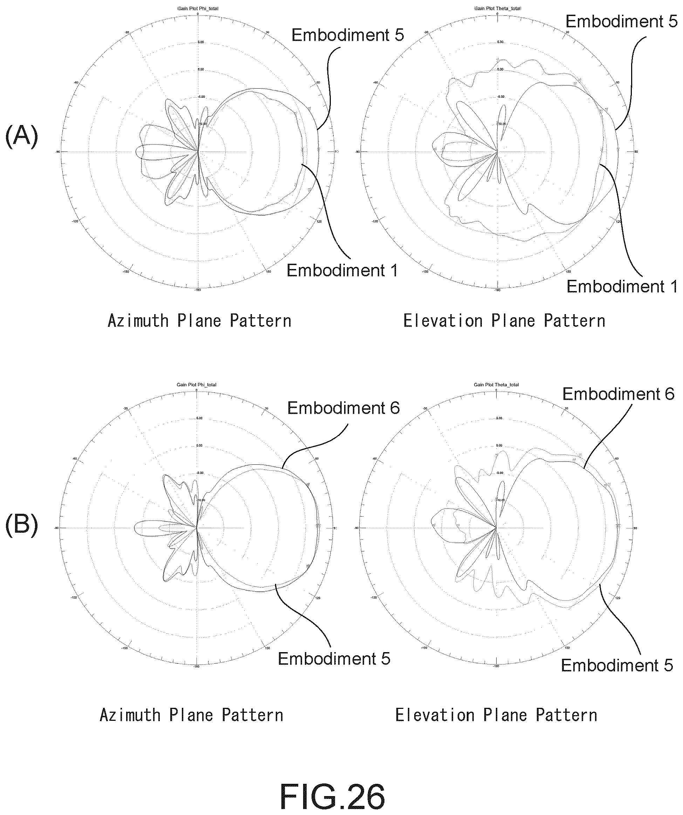

Fig. 25 and Fig. 26 are each a simulation result showing radiation characteristics of the horn antenna 600 according to this embodiment. Part (A) of Fig. 25 shows a voltage standing wave ratio (VSWR), the left side of part (B) of Fig. 25 shows an azimuth plane pattern, and the right side thereof shows an elevation plane pattern. Note that Part (B) of Fig. 25 shows radiation patterns at 60.5 GHz.

Further, Part (A) of Fig. 26 is a diagram showing radiation patterns of the horn antenna 600 according to this embodiment (embodiment 6) and the horn antenna 100 according to the above-mentioned first embodiment (embodiment 1) in comparison with each other, and Part (B) of Fig. 26 is a diagram showing radiation patterns of the horn antenna 600 according to this embodiment (embodiment 6) and the horn antenna 500 according to the above-mentioned fifth embodiment (embodiment 5) in comparison with each other.

As shown in Part (A) of Fig. 25, in accordance with the horn antenna 600 according to this embodiment, the resonance point was near 60 GHz and the band was similar to that in the embodiment 1 (see Part (A) of Fig. 12).

Meanwhile, as shown in Part (A) of Fig. 26, in accordance with this embodiment, the directivity of the main lobe was higher than that in the first embodiment and the antenna gain was improved. This is presumably because the matching with the air layer is improved by interposing the dielectric portion 51 having a predetermined length between the horn portion 20 and the antenna opening 20s.

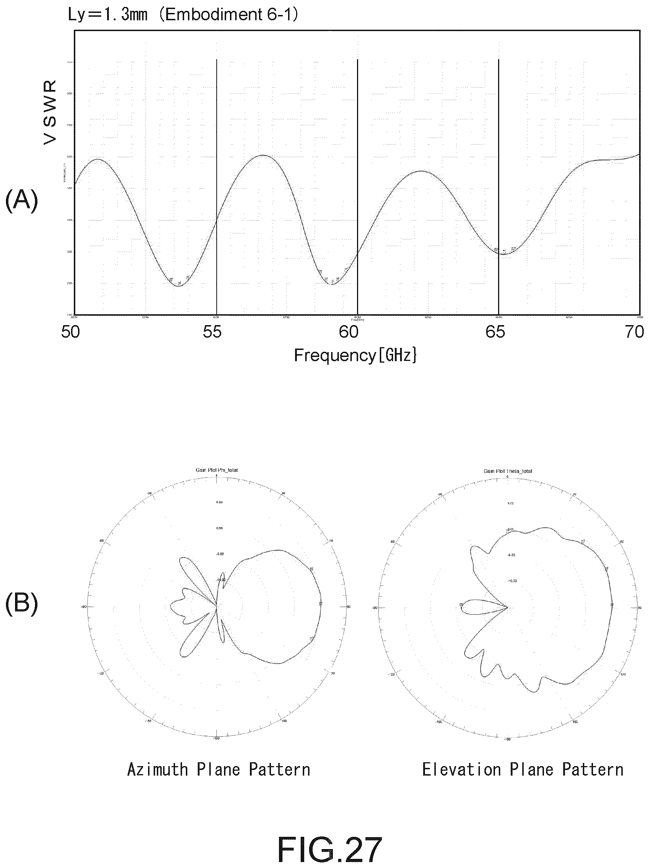

Meanwhile, as shown in Part (B) of Fig. 26, in accordance with this embodiment, the directivity of the main lobe was lower than that in the fifth embodiment. This is presumably because the air hole portions 52 are not provided in the dielectric portion 51. However, from the result of Part (A) of Fig. 26, it was confirmed that a considerable improvement in radiation characteristics can be expected by providing the dielectric portion 51 having the length Ly in the emission end portion of the horn portion 20. In this regard, the results of comparing antenna characteristics by varying the length Ly of the dielectric portion 51 along the Y-axis direction are shown in Fig. 27 to Fig. 31.

### (Embodiment 6-1)

Fig. 27 is a simulation result showing radiation characteristics of a horn antenna when the length Ly of the dielectric portion 51 is set to 1.3 mm (corresponding to λ/2), Part (A) shows a voltage standing wave ratio (VSWR), the left side of Part (B) shows an azimuth plane pattern, and the right side thereof shows an elevation plane pattern. Note that Part (B) of Fig. 25 shows radiation patterns at 60.5 GHz.

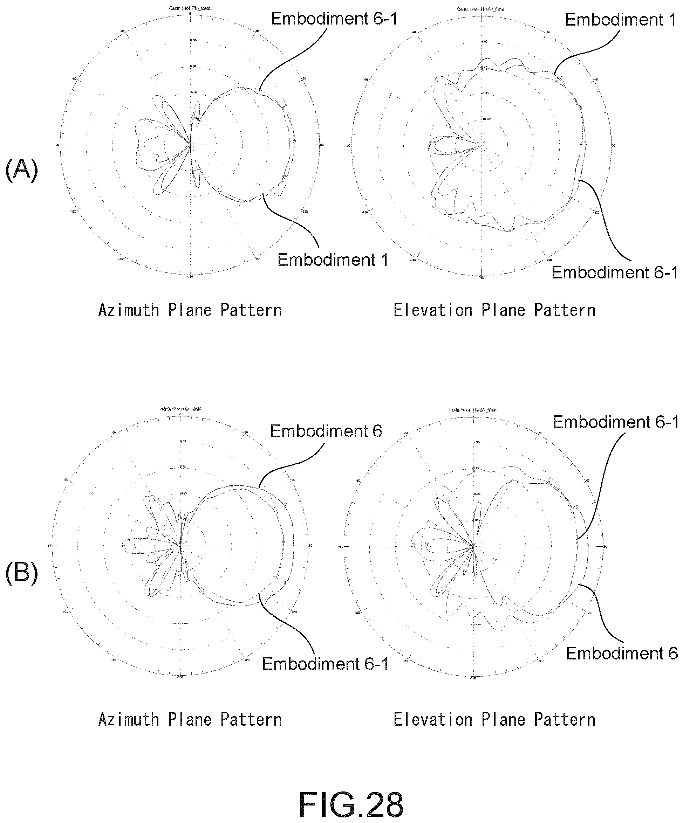

Further, Part (A) of Fig. 28 is a diagram showing radiation patterns of a horn antenna according to this embodiment (embodiment 6-1) and the horn antenna 100 according to the above-mentioned first embodiment (embodiment 1) in comparison with each other, and part (B) of Fig. 28 is a diagram showing radiation patterns of the horn antenna according to this embodiment (embodiment 6-1) and the horn antenna 600 according to the embodiment 6 in comparison with each other.

As shown in Part (A) of Fig. 27, in accordance with the horn antenna according to this embodiment, the resonance point was 59.1 GHz, which was shifted to the lower frequency side than in the embodiment 1.

Further, as shown in Part (A) of Fig. 28, in accordance with this embodiment, the directivity of the main lobe was higher than that in the first embodiment and the antenna gain was improved, but the effect of improving the antenna gain was smaller than that in the embodiment 6.

### (Embodiment 6-2)

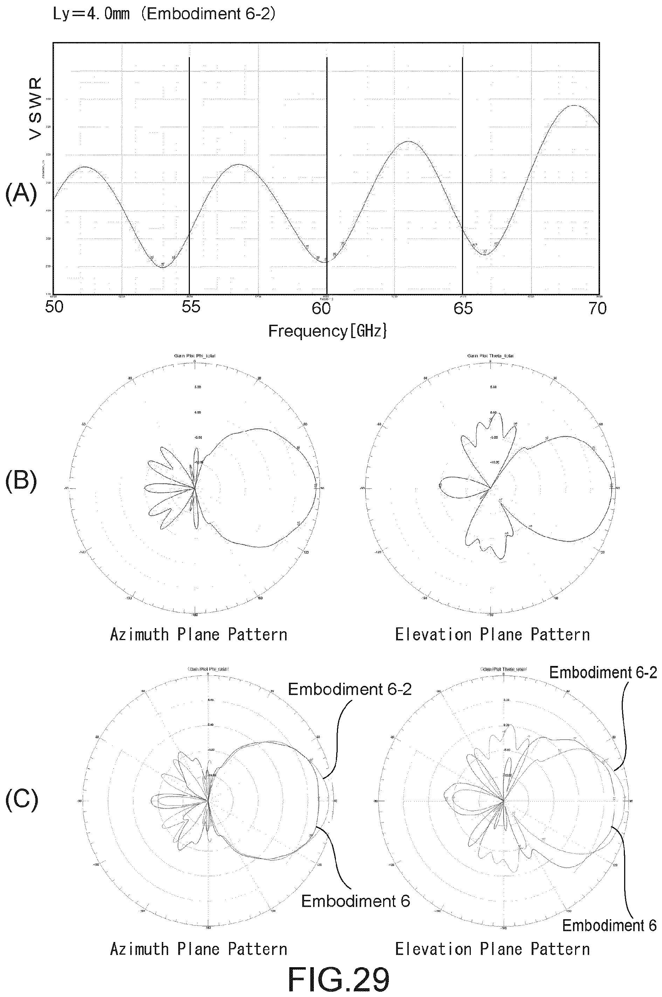

Fig. 29 is a simulation result showing radiation characteristics of a horn antenna when the length Ly of the dielectric portion 51 is set to 4.0 mm (corresponding to 3λ/2), Part (A) shows a voltage standing wave ratio (VSWR), the left side of Part (B) shows an azimuth plane pattern, the right side thereof shows an elevation plane pattern, and Part (C) is a diagram showing radiation patterns of a horn antenna according to this embodiment (embodiment 6-2) and the horn antenna 600 according to the embodiment 6 in comparison with each other. Note that Part (B) of Fig. 29 shows radiation patterns at 60.5 GHz.

As shown in Part (A) of Fig. 29, in accordance with the horn antenna according to this embodiment, the resonance point was 60.0 GHz, which was slightly shifted to the lower frequency side than in the embodiment 1.

Further, as shown in Part (C) of Fig. 29, in accordance with this embodiment, the directivity of the main lobe was higher than that in the embodiment 6 and the antenna gain was improved.

### (Embodiment 6-3)

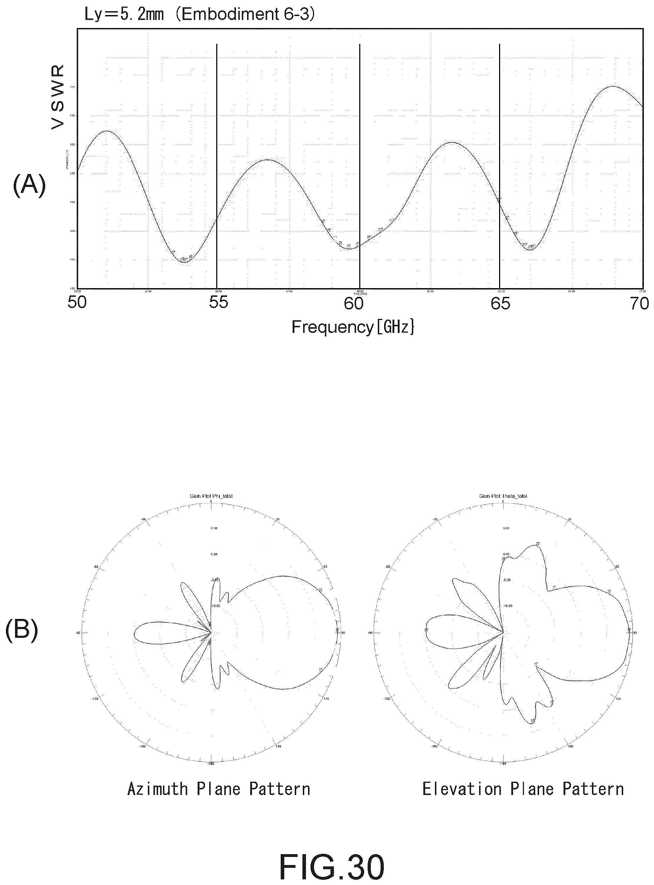

Fig. 30 is a simulation result showing radiation characteristics of a horn antenna when the length Ly of the dielectric portion 51 is set to 5.2 mm (corresponding to 2λ), Part (A) shows a voltage standing wave ratio (VSWR), the left side of Part (B) shows an azimuth plane pattern, and the right side thereof shows an elevation plane pattern. Note that Part (B) of Fig. 30 shows radiation patterns at 60.5 GHz.

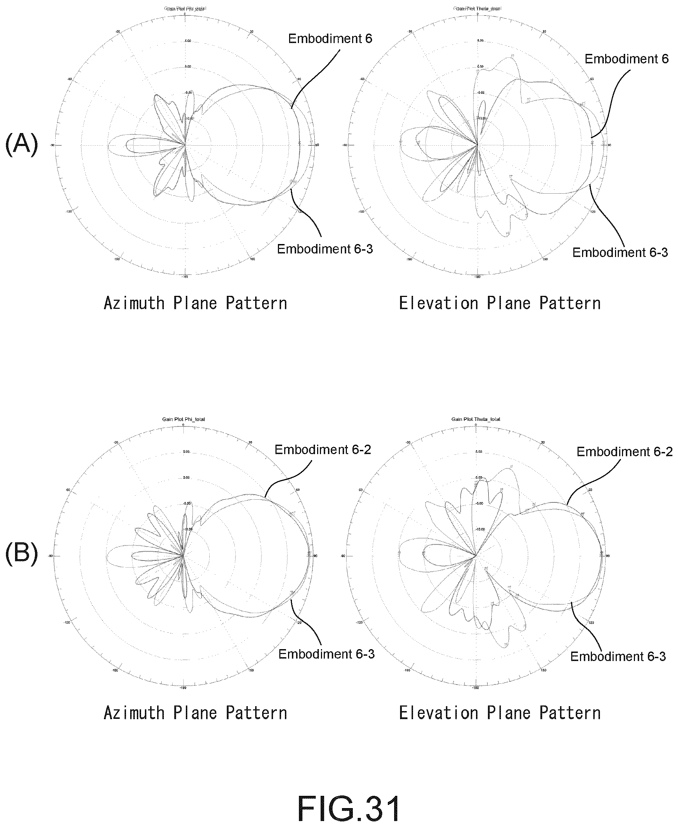

Further, Part (A) of Fig. 31 is a diagram showing radiation patterns of a horn antenna according to this embodiment (embodiment 6-3) and the horn antenna 600 according to the embodiment 6 in comparison with each other, and Part (B) of Fig. 31 is a diagram showing radiation patterns of the horn antenna according to this embodiment (embodiment 6-3) and the horn antenna according to the embodiment 6-2 in comparison with each other.

As shown in Part (A) of Fig. 30, in accordance with the horn antenna according to this embodiment, the resonance point was 59.6 GHz, which was shifted to the lower frequency side than in the embodiment 1.

Further, as shown in Part (A) of Fig. 31, in accordance with this embodiment, the directivity of the main lobe was higher than that in the embodiment 6 and the antenna gain was improved, but the radiation level in the up-and-down direction was higher than that in the embodiment 6-2 as shown in Part (B) of Fig. 31.

As described above, it has been confirmed that the length Ly of the dielectric portion 51 is favorably λ or more and 3λ/2 or less although an antenna gain larger than that in the embodiment 1 can be achieved when the length Ly is λ/2 or more.

### <Seventh embodiment>

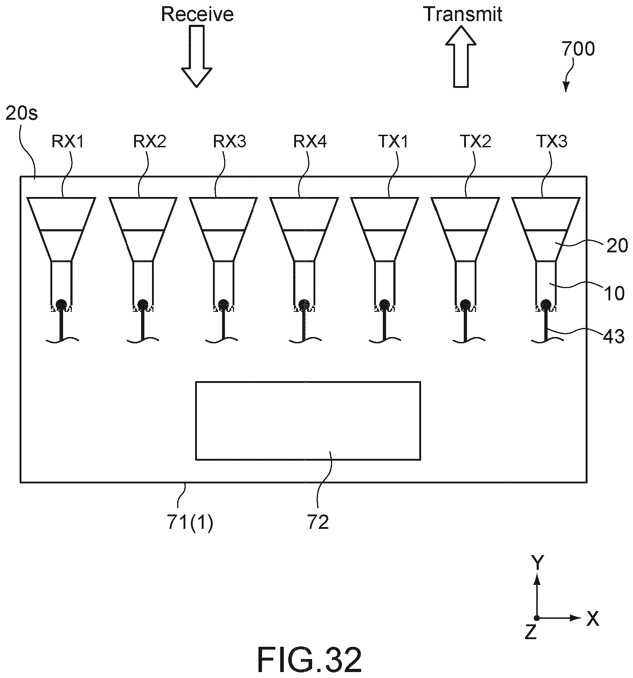

Fig. 32 is a schematic plan view showing an antenna device 700 according to an embodiment of the present technology.

The antenna device 700 includes an antenna module in which a plurality of antennas (TX1 to TX3 and RX1 to RX4) are mounted on one support substrate 71. Note that each of the antennas has a configuration similar to that of the horn antenna 100 according to the above-mentioned first embodiment. The present technology is not limited thereto, and a horn antenna according to another embodiment may be adopted as the antenna.

The plurality of antennas includes three antennas TX1, TX2, and TX3 for transmission and four antennas RX1, RX2, RX3, and RX4 for reception. The respective antennas are arrayed at predetermined intervals in the X-axis direction with the tip of the horn portion 20 facing one side of the support substrate 71 on the side of the long side.

The support substrate 71 is typically a wiring board and includes, for example, the dielectric multilayer substrate 1 shown in Fig. 4 in this embodiment. That is, the plurality of antennas is crated inside the common dielectric multilayer substrate 1. In this example, one side surface of the support substrate 71 facing the horn portion 20 of each of the antennas forms the antenna opening 20s.

A signal processing circuit 72 is further mounted on the support substrate 71. The signal processing circuit 72 includes one or more semiconductor integrated circuit (IC) parts and peripheral parts (passive parts) thereof. The signal processing circuit 72 is electrically connected to each antenna via the signal line 43 and is configured to be capable of individually controlling each antenna. The signal processing circuit 72 typically includes a processor, a modulator, a mixer, an AD converter, and the like.

The sensor device 700 configured as described above according to this embodiment transmits, to an object, radio waves (millimeter waves) from the plurality of antennas TX1 to TX3 for transmission and receives the reflected waves by the plurality of antennas RX1 to RX4 for reception. Since the respective antennas are arranged with a phase shift, it is possible to acquire data as if there were a total of 12 antennas by the three antennas for transmission and the four antennas for reception. As a result, it is possible to detect the position, moving speed, distance, and the like of the object with high accuracy.

In accordance with this embodiment, since a plurality of antennas is mounted on the same substrate and the antenna opening 20s serving as a transmission/reception surface of radio waves is formed on one side surface portion of the substrate, it is possible to thin the antenna device as compared with an existing phased patch antenna or the like.

For example, in the case where the antenna device 700 is sed in a vehicle, the antenna device can be mounted in a small space on the front portion of the vehicle.

Further, the antenna device 700 can be incorporated into an image display apparatus such as a television set and can be configured as a sensor that detects a gesture operation of a user and generates a control signal for executing power supply control, channel selection control, volume control, and the like. In this case, the antenna device 700 can be incorporated in a narrow space such as a picture frame and a nameplate in front of the image display apparatus.

Further, the antenna device 700 can be configured also as a sensor that detects biological information such as pulse and respiration. For example, by incorporation the antenna device 700 into a controller of a game console, it is possible to detect the degree of excitement of a user who plays the game.

### [Reference Example]

### <Reference Example 1>

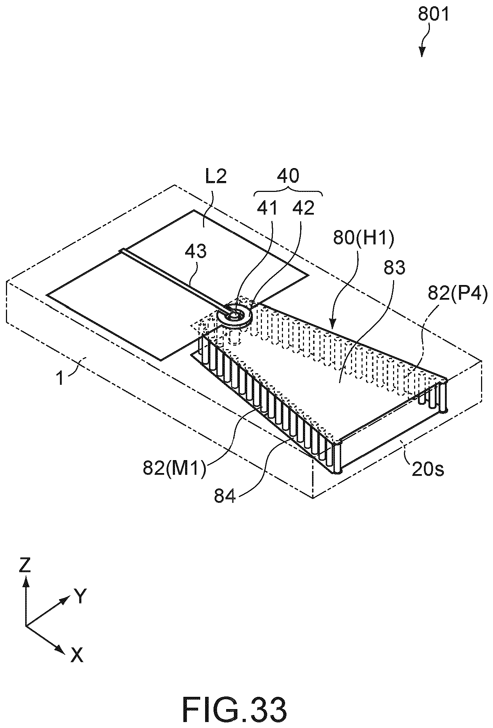

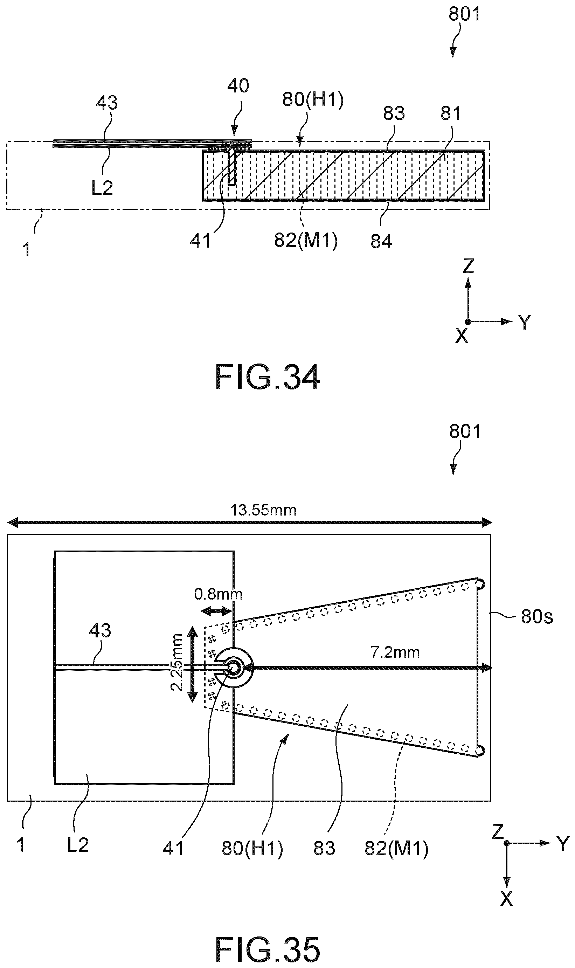

Fig. 33 is a partially transparent perspective view of a horn antenna 801 according to a Reference Example 1 of the present technology, Fig. 34 is a cross-sectional side view of the central portion of the horn antenna 801 in the width direction (X-axis direction), and Fig. 35 is a schematic plan view of the horn antenna 801.

Hereinafter, configurations different from those in the first embodiment will be mainly described, configurations similar to those in the first embodiment will be denoted by similar reference symbols, and description thereof is omitted or simplified.

The horn antenna 801 according to this Reference Example is provided inside the dielectric multilayer substrate 1 and includes a horn portion 80 and the power supply unit 40. The horn antenna 801 may be configured as an antenna for transmission, may be configured as an antenna for reception, or may be configured as an antenna for transmission and reception. Here, a case where the horn antenna 801 is configured as an antenna for reception will be described as an example.

The horn antenna 801 is different from the horn antenna 100 (Fig. 1) according to the first embodiment in that the power supply unit 40 is connected to the horn portion 80 without the waveguide portion 10 and the horn portion 80 includes a single widening portion. The details thereof will be described below.

In this Reference Example, the horn portion 80 includes a first dielectric block 81 that supports the power supply unit 40, and a first post wall 82.

The first dielectric block 81 is formed to have a trapezoidal cube. The first dielectric block 81 is a stacked body of the dielectric layers 1C, 1D, and 1E on the inner layer side of the dielectric multilayer substrate 1 shown in Fig. 4 and is a layer including only a dielectric in which the wiring layers L4 and L5 are not present on the interfaces of these dielectric layers 1C to 1E.

The first post wall 82 includes a plurality of conductive columnar bodies M1 (first conductive columnar bodies) passing through the first dielectric block 81 and demarcates a first waveguide H1 whose width increases as a distance from the power supply unit 40 increases in the first dielectric block 81. The first waveguide H1 is a dielectric waveguide that forms a transmission path for radio waves. The conductive columnar bodies M1 form both side walls of the first waveguide H1 and a rear wall located behind the feeding probe 41.

The conductive columnar bodies M1 are each a columnar body formed of a metal and connect between two first conductor layers 83 and 84 facing each other across the first dielectric block 81 in the thickness direction (Z-axis direction). One first conductor layer 83 corresponds to the wiring layer L3 in Fig. 4, and the other first conductor layer 84 corresponds to the wiring layer L6 in Fig. 4. The first conductor layers 83 and 84 are each formed to have a trapezoidal shape, respectively demarcate the top surface and the bottom surface of the first waveguide H1, and are typically connected to a ground potential.

The conductive columnar bodies M1 are linearly arrayed along two oblique sides of the first conductor layers 83 and 84, but are not limited thereto and may be arrayed in a curved line. In order to confine radio waves in the first waveguide H1 by the first post wall 82, the conductive columnar bodies M1 are arrayed with a gap equal to or less than one-fourth (0.66 mm) of a wavelength of a radio wave propagating through the first waveguide H1.

The tip portion of the horn portion 80 in the Y-axis direction forms an antenna opening 80s that radio waves enter. This antenna opening 80s may be in contact with the air surface or may be covered with the dielectric layer of the dielectric multilayer substrate 1.

The sizes of the respective portions of the horn antenna 801 are not particularly limited. For example, the distance from the feeding probe 41 to the antenna opening 80s along the Y-axis direction is 7.2 mm, the length of the base of the horn portion 80 on the side of the short side along the X-axis direction is 2.25 mm, the length of the base of the horn portion 80 on the side of the long side along the X-axis direction is 8 mm, the length from the base of the horn portion 80 on the side of the short side to the power supply unit 41 along the Y-axis direction is 0.8 mm, and the length of the dielectric multilayer substrate 1 along the Y-axis direction is 13.55 mm.

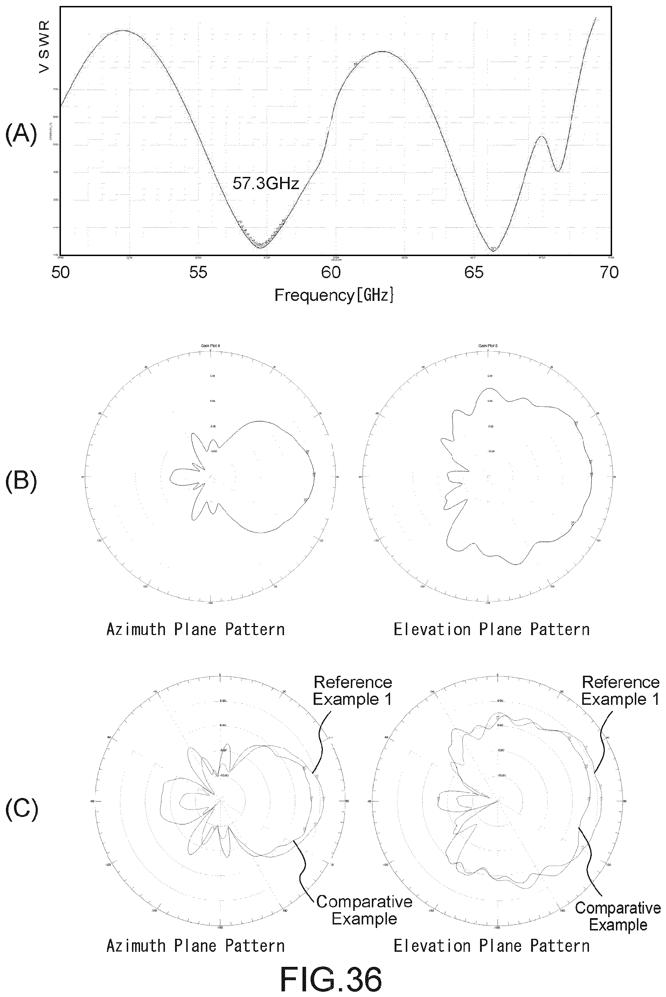

Fig. 36 is a simulation result showing radiation characteristics of the horn antenna 801 according to this example, Part (A) shows a voltage standing wave ratio (VSWR), the left side of Part (B) shows an azimuth plane pattern, the right side thereof shows an elevation plane pattern, and Part (C) is a diagram showing radiation patterns of the horn antenna 801 according to this example (Reference Example 1) and the horn antenna 110 according to the above-mentioned Comparative Example (Fig. 9) in comparison with each other. Note that Part (B) shows radiation patterns at 57.3 GHz.

As shown in Part (A) of Fig. 36, in accordance with the horn antenna 801 according to this example, the reception frequency was 57.3 GHz, which was shifted to the lower frequency side than in the Comparative Example. Further, the receivable band was expanded as compared with that in the Comparative Example.

Further, as shown in Part (C) of Fig. 36, in accordance with this example, the directivity of the main lobe was higher than that in the Comparative Example and the antenna gain was improved.

### <Reference Example 2>

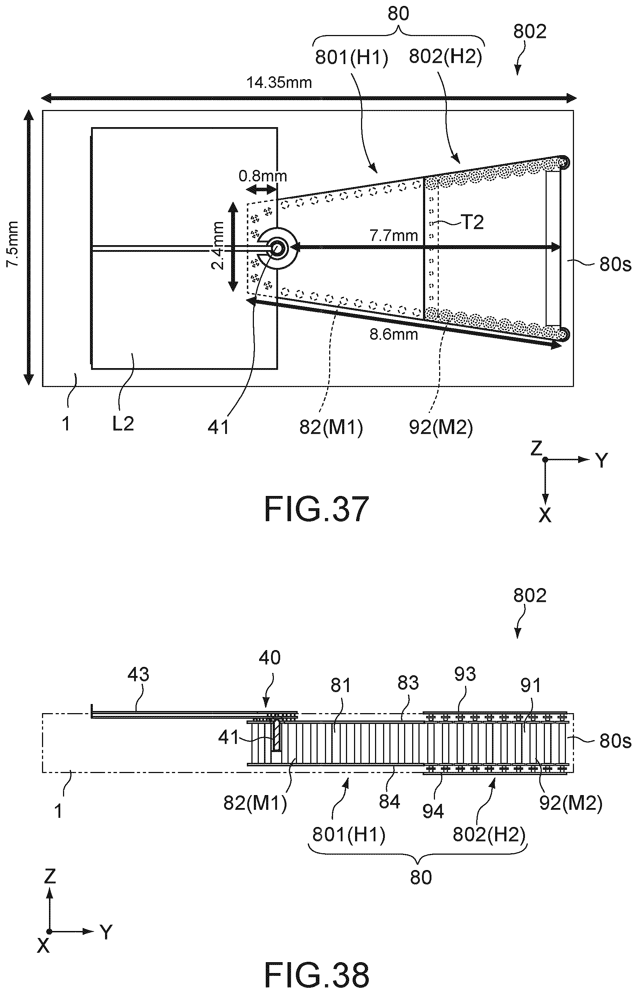

Fig. 37 is a schematic plan view showing a horn antenna 802 according to a Reference Example 2 of the present technology, and Fig. 38 is a cross-sectional side view of the central portion of the horn antenna 802 in the width direction (X-axis direction).

Hereinafter, configurations different from those in the Reference Example 1 will be mainly described, configurations similar to those in the Reference Example 1 will be denoted by similar reference symbols, and description thereof is omitted or simplified.

In the horn antenna 802 according to this example, the horn portion 80 is different from that in the Reference Example 1 in that it includes a first widening portion 801 and a second widening portion 802 similarly to the first embodiment.

The first widening portion 201 includes the first dielectric block 81 and the first post wall 82.

The first dielectric block 81 is formed to have a trapezoidal cube. The first dielectric block 81 is a stacked body of the dielectric layers 1C, 1D, and 1E on the inner layer side of the dielectric multilayer substrate 1 shown in Fig. 4, and is a layer including only a dielectric in which the wiring layers L4 and L5 are not present on the interfaces of these dielectric layers 1C to 1E.

The first post wall 82 includes the plurality of conductive columnar bodies M1 passing through the first dielectric block 81 and demarcates the first waveguide H1 whose width increases as a distance from the feeding probe 41 increases in the first dielectric block 81. The first waveguide H1 is a dielectric waveguide that forms a transmission path for radio waves. The conductive columnar bodies M1 form both side walls of the first waveguide G1 and a rear wall located behind the feeding probe 41.

The conductive columnar bodies M1 are each a columnar body formed of a metal and connect between the two first conductor layers 83 and 84 facing each other across the first dielectric block 81 in the thickness direction (Z-axis direction). One first conductor layer 83 corresponds to the wiring layer L3 in Fig. 4, and the other first conductor layer 84 corresponds to the wiring layer L6 in Fig. 4. The first conductor layers 83 and 84 are each formed to have a trapezoidal shape, respectively demarcate the top surface and the bottom surface of the first waveguide H1, and are typically connected to a ground potential.

The conductive columnar bodies M1 are linearly arrayed along two oblique sides of the first conductor layers 83 and 84, but are not limited thereto and may be arrayed in a curved line. In order to confine radio waves in the first waveguide H1 by the first post wall 82, the conductive columnar bodies M1 are arrayed with a gap equal to or less than one-fourth (0.66 mm) of a wavelength of a radio wave propagating through the first waveguide H1.

Meanwhile, the second widening portion 802 includes a second dielectric block 91 and a second post wall 92.

The second dielectric block 91 is formed to have a trapezoidal cube thicker than the first dielectric block 81. The second dielectric block 91 is a stacked body of the dielectric layers 1A, 1B, 1C, 1D, 1E, 1F, and 1G in the dielectric multilayer substrate 1 shown in Fig. 4 and is a layer including only a dielectric in which the wiring layers L2 to L7 are not present on the interfaces of these dielectric layers 1A to 1G.

The second post wall 92 includes a plurality of conductive columnar bodies M2 (second conductive columnar bodies) passing through the second dielectric block 91 and demarcates a second waveguide H2 whose width increases as a distance from the first waveguide H1 increases in the second dielectric block 91. The second waveguide H2 is a dielectric waveguide that forms a transmission path for radio waves. The conductive columnar bodies M2 form both side walls of the second waveguide H2.

The conductive columnar bodies M2 are each a columnar body formed of a metal and connect between two second conductor layers 93 and 94 facing each other across the second dielectric block 91 in the thickness direction (Z-axis direction). One second conductor layer 93 corresponds to the wiring layer L1 in Fig. 4, and the other second conductor layer 94 corresponds to the wiring layer L8 in Fig. 4. The second conductor layers 93 and 94 are each formed to have a trapezoidal shape having one bottom surface on the side of the first waveguide H1, respectively demarcate the top surface and the bottom surface of the second waveguide H2, and are typically connected to a ground potential. The second conductor layer 93 is electrically connected to the first conductor layer 83 via a plurality of interlayer connection portions T2. Similarly, the second conductor layer 94 is electrically connected to the first conductor layer 84.

Note that in the illustrated example, the conductive columnar bodies M2 forming the second post wall 92 each include a columnar body having the same height as those of the conductive columnar bodies M1 forming the first post wall 82, and the upper and lower end portions of the conductive columnar bodies M2 are electrically connected to the second conductor layers 93 and 94 via the interlayer connection portions. The present technology is not limited thereto, and the conductive columnar bodies M2 may each include a columnar body having a height corresponding to the facing distance between the second conductor layers 93 and 94.

The conductive columnar bodies M2 are linearly arrayed along two oblique sides of the second conductor layers 93 and 94. In this embodiment, as shown in Fig. 37, the second post wall 92 is disposed on the same straight line as the first post wall 82. In order confine radio waves in the second waveguide H2 by the second post wall 92, the conductive columnar bodies M2 are arrayed with a gap equal to or less than one-fourth (0.66 mm) of a wavelength of a radio wave propagating through the second waveguide H2.

The sizes of the respective portions of the horn antenna 802 are not particularly limited. For example, the distance from the feeding probe 41 to the antenna opening 80s along the Y-axis direction is 7.7 mm, the length of the base of the horn portion 80 on the side of the short side along the X-axis direction is 2.4 mm, the length of the base of the horn portion 80 on the side of the long side along the X-axis direction is 8 mm, the length from the base of the horn portion 80 on the side of the short side to the power supply unit 41 along the Y-axis direction is 0.8 mm, the length of the oblique side of the horn portion 80 is 8.6 mm, the length of the dielectric multilayer substrate 1 along the X-axis direction is 7.5 mm, and the length of the dielectric multilayer substrate 1 along the Y-axis direction is 14.35 mm.

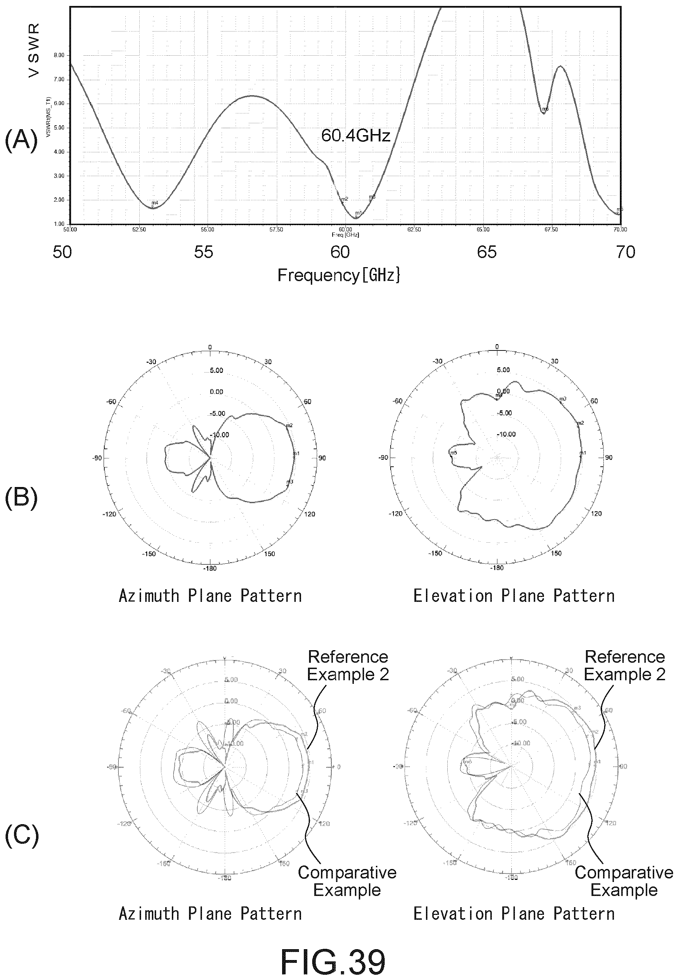

Fig. 39 is a simulation result showing radiation characteristics of the horn antenna 802 according to this example, Part (A) shows a voltage standing wave ratio (VSWR), the left side of Part (B) shows an azimuth plane pattern, the right side thereof shows an elevation plane pattern, and Part (C) is a diagram showing radiation patterns of the horn antenna 802 according to this example (Reference Example 2) and the horn antenna 110 according to the above-mentioned Comparative Example (Fig. 9) in comparison with each other. Note that Part (B) shows radiation patterns at 60.5 GHz.

As shown in Part (A) of Fig. 39, in accordance with the horn antenna 802 according to this example, the reception frequency was 60.4GHz, which was shifted to the higher frequency side than in Reference Example 1. Further, the receivable band was expanded as compared with that in the Comparative Example.

Further, as shown in Part (C) of Fig. 39, in accordance with this example, the directivity of the main lobe was higher than that in the Comparative Example and the antenna gain was improved.

### <Reference Example 3>

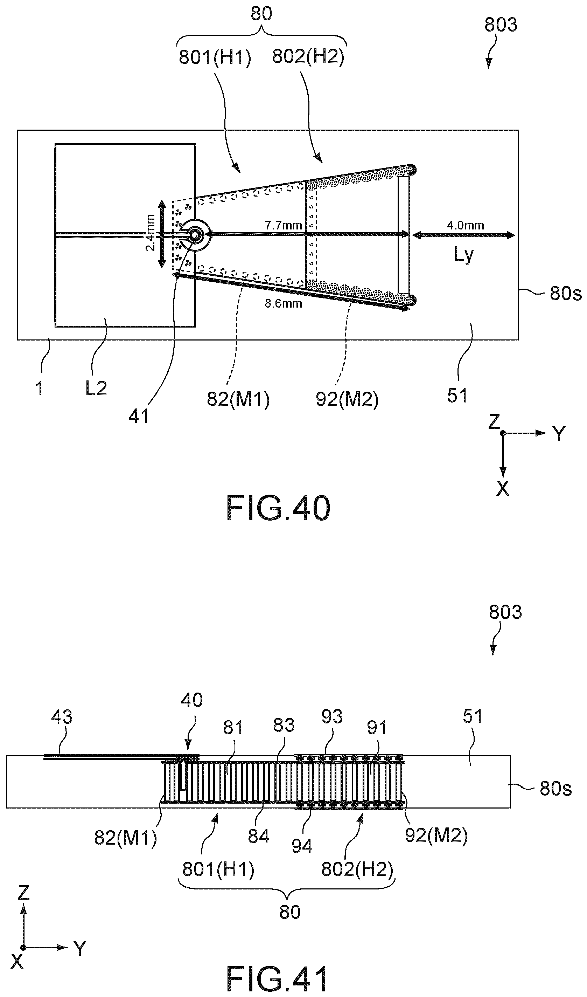

Fig. 40 is a schematic plan view showing a horn antenna 803 according to a Reference Example 3 of the present technology, and Fig. 41 is a cross-sectional side view of the central portion of the horn antenna 803 in the width direction (X-axis direction).

Hereinafter, configurations different from those in the Reference Example 2 will be mainly described, configurations similar to those in the Reference Example 2 will be denoted by similar reference symbols, and description thereof is omitted or simplified.

The horn antenna 803 according to this example is different from that in the above-mentioned Reference Example 2 in that it includes the dielectric portion 51 that covers an opening of the horn portion 80. The dielectric portion 51 is a stacked body of the dielectric layers 1A to 1G in the dielectric multilayer substrate 1 shown in Fig. 4 and is a layer including only a dielectric in which the wiring layers L2 to L7 are not present on the interfaces of these dielectric layers 1A to 1G, as in the sixth embodiment. The tip surface of the dielectric portion 51 in the Y-axis direction forms the antenna opening 80s.

The length Ly of the dielectric portion 51 along the Y-axis direction is not particularly limited and only needs to be at least λ/2 or more. In this example, the length Ly is 1.5 λ (4.0 mm). The other portions are also formed to have the same sizes as those in the above-mentioned Reference Example 2.

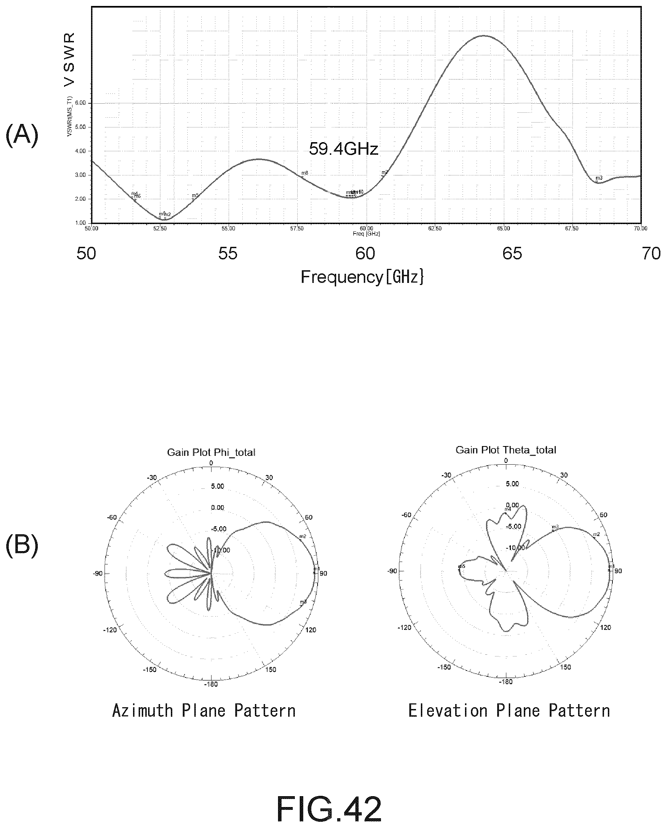

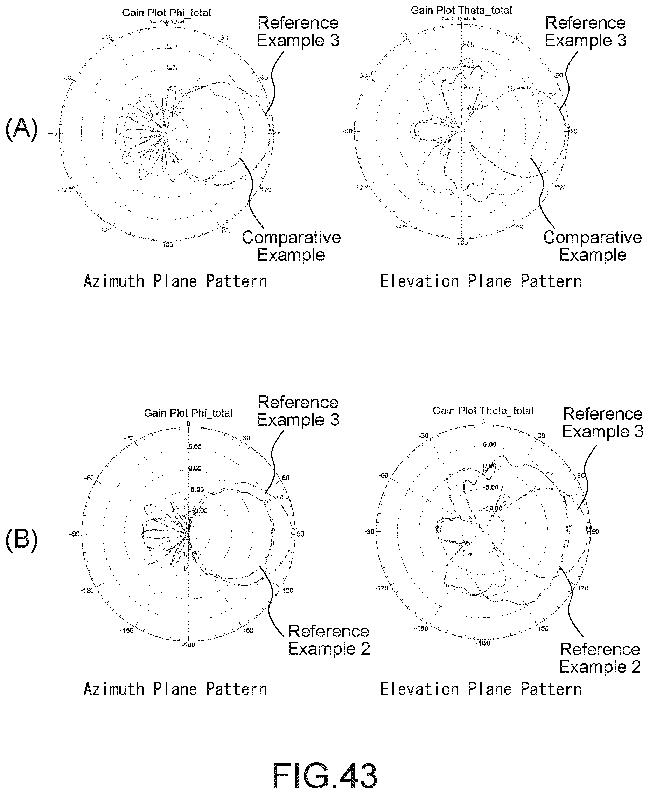

Fig. 42 and Fig. 43 are each a simulation result showing radiation characteristics of the horn antenna 803 according to this example. Part (A) of Fig. 42 shows a voltage standing wave ratio (VSWR), the left side of Part (B) of Fig. 42 shows an azimuth plane pattern, and the right side thereof shows an elevation plane pattern. Note that Part (B) shows radiation patterns at 60.5 GHz.

Part (A) of Fig. 43 is a diagram showing radiation patterns of the horn antenna 803 according to this example (Reference Example 3) and the horn antenna 110 according to the above-mentioned Comparative Example (Fig. 9) in comparison with each other. Part (B) of Fig. 43 is a diagram showing radiation patterns of the horn antenna 803 according to this example (Reference Example 3) and the horn antenna 802 according to the above-mentioned Reference Example 2 in comparison with each other.

As shown in Part (A) of Fig. 42, in accordance with the horn antenna 803 according to this example, the reception frequency was 59.4 GHz and the receivable band was expanded as compared with that in the Comparative Example, although the reflection loss increased.

Further, as shown in Part (A) of Fig. 43, in accordance with this example, the directivity of the main lobe was higher than that in the Comparative Example and the antenna gain was significantly improved.

Further, as shown in Part (B) of Fig. 43, in accordance with this example, the directivity of the main lobe was higher than that in the Reference Example 2 and the antenna gain was significantly improved.

### <Reference Example 4>

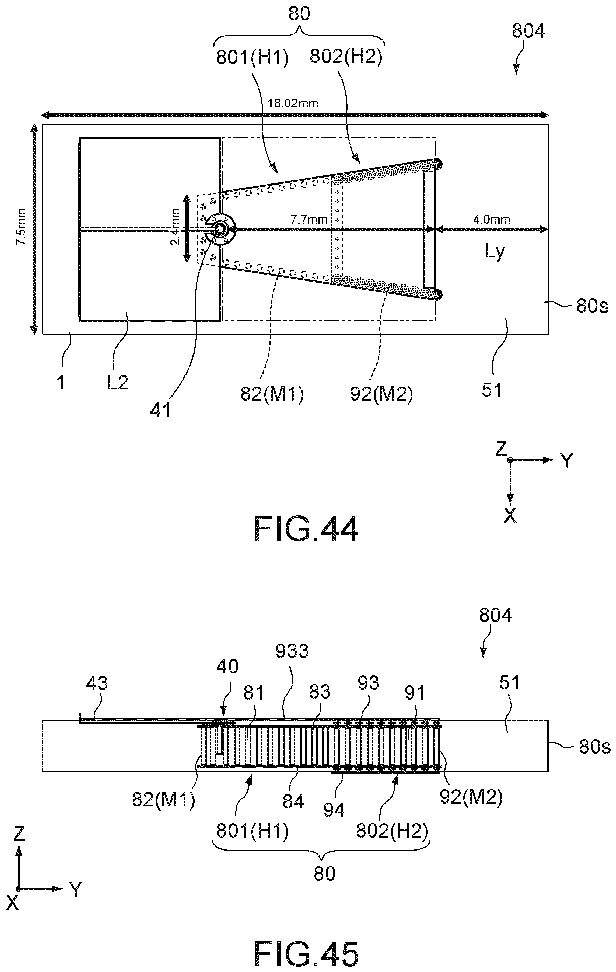

Fig. 44 is a schematic plan view showing a horn antenna 804 according to a Reference Example 4 of the present technology. Fig. 45 is a cross-sectional side view of the central portion of the horn antenna 804 in the width direction (X-axis direction).

Hereinafter, configurations different from those in the Reference Example 3 will be mainly described, configurations similar to those in the Reference Example 3 will be denoted by similar reference symbols, and description thereof is omitted or simplified.

The horn antenna 804 according to this example is different from that in the Reference Example 3 in that it includes a shield layer 933 that covers the first widening portion 801 of the horn portion 80. The shield layer 933 is for suppressing radio waves emitted from the first conductor layer 83 and the second conductor layer 93 by the coupling action of the electric field formed by the transmission line of the power supply unit 40 with the horn antenna 804, as in the fourth embodiment.

The shield layer 933 is formed by extending the second conductor layer 93 right above the first widening portion 801 of the horn portion 80. The shield layer 933 is electrically connected to the first conductor layer 83 via a plurality of through holes (interlayer connection portions). Further, the shield layer 933 includes the wiring layer L1 that is connected to a ground potential and is electrically insulated from the signal line 43.

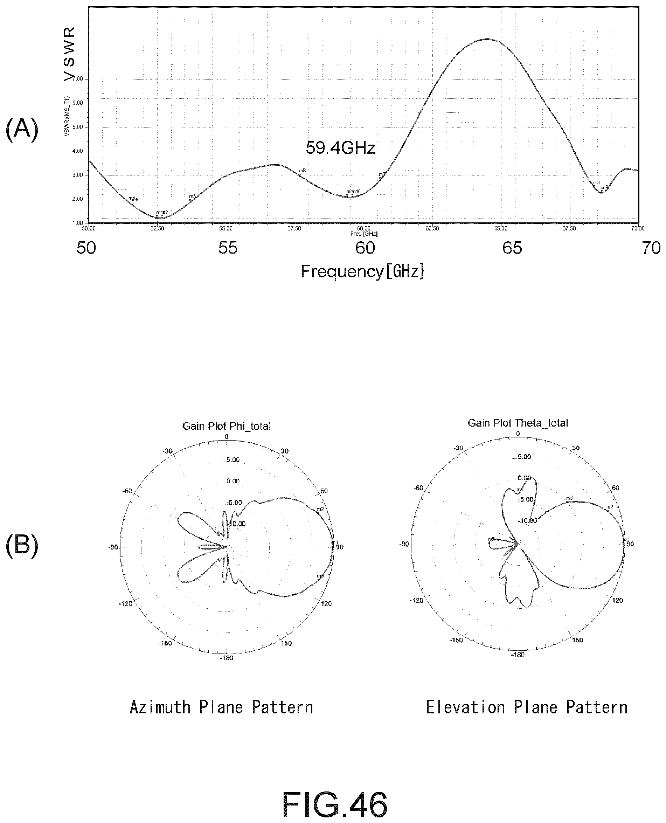

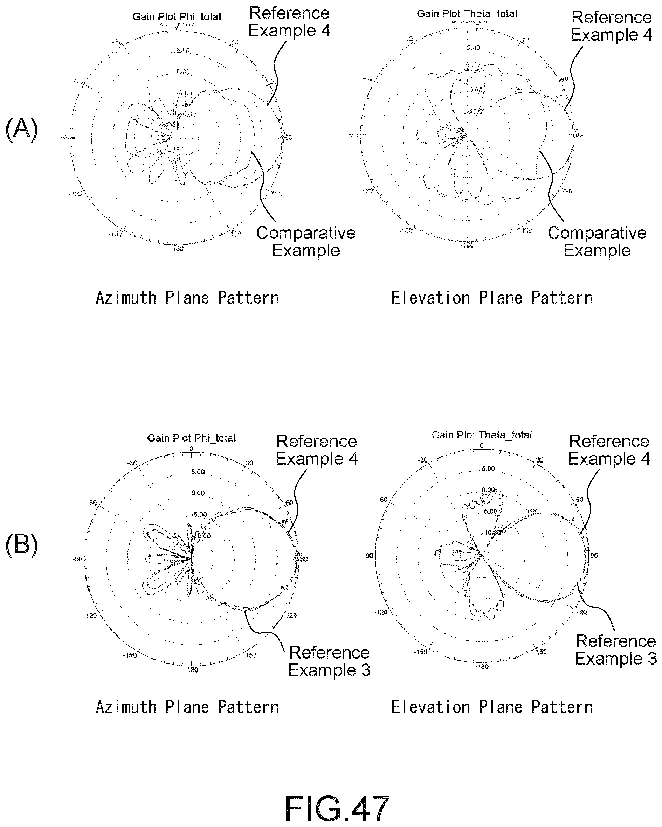

Fig. 46 and Fig. 47 are each a simulation result showing radiation characteristics of the horn antenna 804 according to this example. Part (A) of Fig. 46 shows a voltage standing wave ratio (VSWR), the left side of Part (B) of Fig. 46 shows an azimuth plane pattern, and the right side thereof shows an elevation plane pattern. Note that Part (B) shows radiation patterns at 60.5 GHz. Further, the length of the feeding probe 41 protruding from the first conductor layer 83 to the first waveguide H1 was set to 0.75 mm.

Part (A) of Fig. 47 is a diagram showing radiation patterns of the horn antenna 804 according to this example (Reference Example 4) and the horn antenna 110 according to the above-mentioned Comparative Example (Fig. 9). Part (B) of Fig. 47 is a diagram showing radiation patterns of the horn antenna 804 according to this example (Reference Example 4) and the horn antenna 803 according to the above-mentioned Reference Example 3 in comparison with each other.

As shown in Part (A) of Fig. 46, in accordance with the horn antenna 804 according to this example, the reception frequency was 59.4 GHz, and the receivable band was expanded as compared with that in the Comparative Example, although the reflection loss increased.

Further, as shown in Part (A) of Fig. 47, in accordance with this example, the directivity of the main lobe was higher than that in the Comparative Example and the antenna gain was significantly improved.

Further, as shown in Part (B) of Fig. 47, in accordance with this example, the directivity of the main lobe was higher than that in the Reference Example 3 and the antenna gain was slightly (0.5 dB) improved.

### <Reference Example 5>

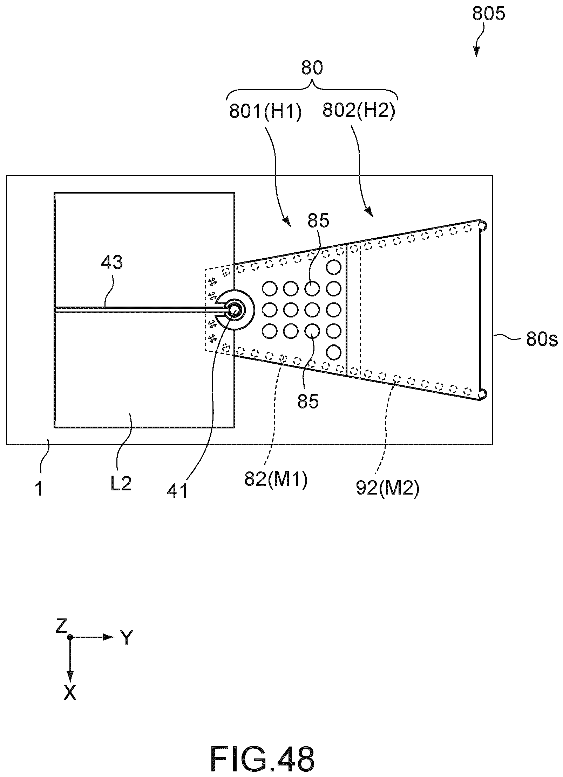

Fig. 48 is a schematic plan view showing a horn antenna 805 according to a Reference Example 5 of the present technology.

Hereinafter, configurations different from those in the Reference Example 2 will be mainly described, configurations similar to those in the Reference Example 2 will be denoted by similar reference symbols, and description thereof is omitted or simplified.

The horn antenna 805 according to this example is different from that in the Reference Example 2 in that a plurality of air hole portions 85 is provided in the first widening portion 801 of the horn portion 80. The air hole portions 85 are for suppressing the decrease in antenna gain due to the impedance mismatch between the dielectric forming the substrate and space, as in the second and third embodiments.

In this example, the air hole portion 85 is a through hole passing through the formation region of the first dielectric block 81 and the first conductor layers 83 and 84 (see Fig. 38) constituting the first waveguide H1 in the Z-axis direction, and the inside thereof is air in communication with the outside air. The air hole portion 85 is typically cylindrical. However, it goes without saying that the shape of the air hole portion 85 is not limited thereto, and may be oval, rectangular, or another cylindrical shape, for example.

The opening width (diameter) of the air hole portions 85 is smaller than the wavelength λ of a radio wave propagating through the first dielectric block 81, and is favorably λ/4 (0.66 mm in this example) or less. As a result, it is possible to prevent radio waves from leaking from the air hole portions 85.

The diameter, array number, and array form of the air hole portions 85 can be arbitrarily set in accordance with the intended dielectric constant of the first waveguide H1. In this example, the diameter of the air hole portions 85 is set to 0.4 mm and the air hole portions 85 are formed in the first waveguide H1 such that the porosity of the first waveguide H1 is 6.3%. In this case, the dielectric constant of the first waveguide H1 changes from 3.6 before forming the air hole portions 85 to 3.37. At this time, the wavelength of a radio wave of 60 GHz propagating through the first waveguide H1 is 3.17 mm.

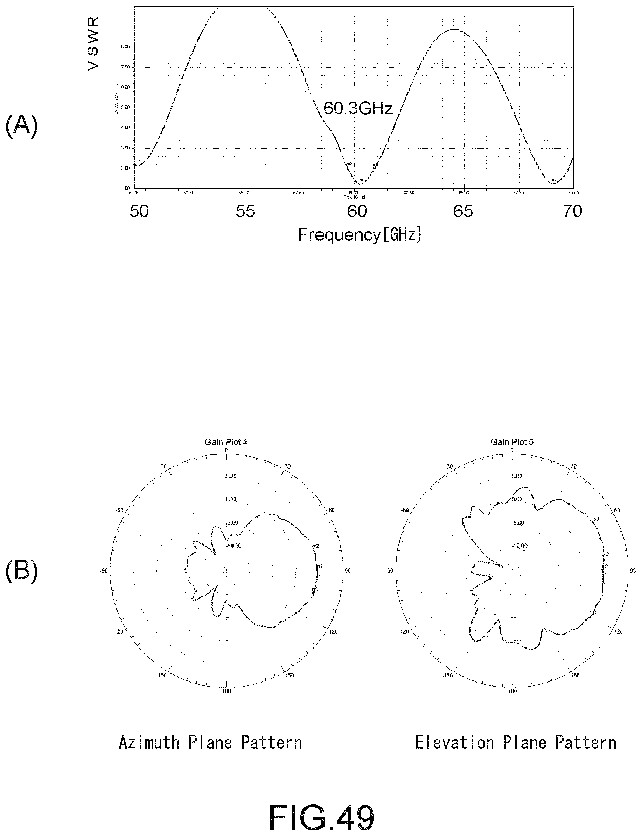

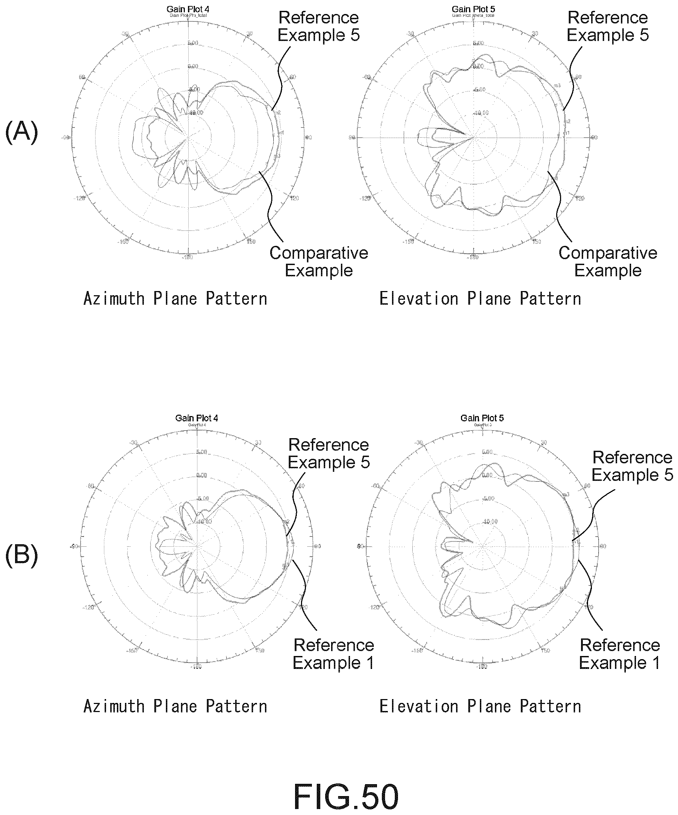

Fig. 49 and Fig. 50 are each a simulation result showing radiation characteristics of the horn antenna 805 according to this example. Part (A) of Fig. 49 shows a voltage standing wave ratio (VSWR), the left side of Part (B) of Fig. 49 shows an azimuth plane pattern, and the right side thereof shows an elevation plane pattern. Note that Part (B) shows radiation patterns at 60.5 GHz.

Part (A) of Fig. 50 is a diagram showing radiation patterns of the horn antenna 805 according to this example (Reference Example 5) and the horn antenna 110 according to the above-mentioned Comparative Example (Fig. 9) in comparison with each other. Part (B) of Fig. 50 is a diagram showing radiation patterns of the horn antenna 805 according to this example (Reference Example 5) and the horn antenna 801 according to the above-mentioned Reference Example 1 in comparison with each other.

As shown in Part (A) of Fig. 49, in accordance with the horn antenna 805 according to this example, the reception frequency was 60.3 GHz, and the receivable band was expanded as compared with that in the Comparative Example.

Further, as shown in Part (A) of Fig. 50, in accordance with this example, the directivity of the main lobe was higher than that in the Comparative Example and the antenna gain was improved.

Meanwhile, as shown in Part (B) of Fig. 50, in accordance with this example, the directivity of the main lobe was lower than that in the Reference Example 1 and the antenna gain was slightly reduced.

### <Reference Example 6>

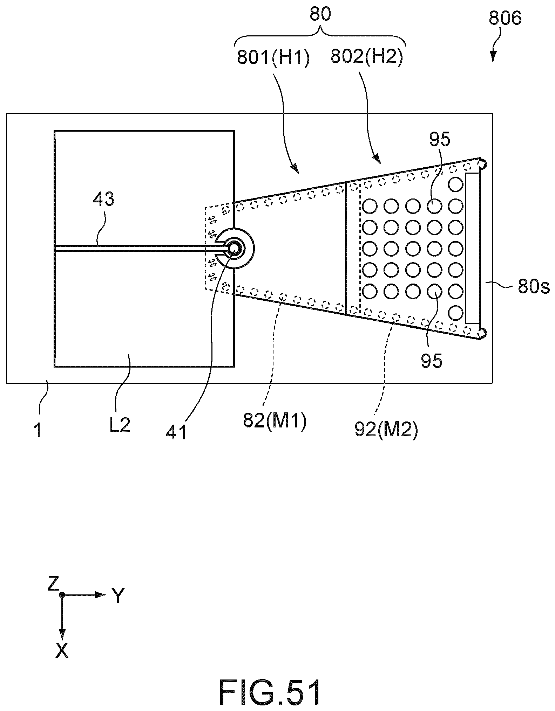

Fig. 51 is a schematic plan view showing a horn antenna 806 according to a Reference Example 6 of the present technology.

Hereinafter, configurations different from those in the Reference Example 2 will be mainly described, configurations similar to those in the Reference Example 2 will be denoted by similar reference symbols, and description thereof is omitted or simplified.

The horn antenna 806 according to this example is different from that in the Reference Example 2 in that a plurality of air hole portions 95 is provided in the second widening portion 802 of the horn portion 80. The air hole portions 95 are for suppressing the decrease in antenna gain due to the impedance mismatch between the dielectric forming the substrate and space, as in the second and third embodiments.

In this example, the air hole portion 95 is a through hole passing through the formation region of the second dielectric block 91 and the second conductor layers 93 and 94(see Fig. 38) constituting the second waveguide H2 in the Z-axis direction, and the inside thereof is air in communication with the outside air. The air hole portion 95 is typically cylindrical. However, it goes without saying that the shape of the air hole portion 95 is not limited thereto, and may be oval, rectangular, or another cylindrical shape, for example.

The opening width (diameter) of the air hole portions 95 is smaller than the wavelength λ of a radio wave propagating through the second dielectric block 91, and is favorably λ/4 (0.66 mm in this example) or less. As a result, it is possible to prevent radio waves from leaking from the air hole portions 95.

The diameter, array number, and array form of the air hole portions 95 can be arbitrarily set in accordance with the intended dielectric constant of the second waveguide H2. In this example, the diameter of the air hole portion 95 is set to 0.4 mm, and the air hole portions 95 are formed in the second waveguide H2 such that the porosity of the second waveguide H2 is 12.24%. In this case, the dielectric constant of the second waveguide H2 changes from 3.6 before forming the air hole portions 95 to 3.15. At this time, the wavelength of a radio wave of 60 GHz propagating through the second waveguide H2 is 3.13 mm.

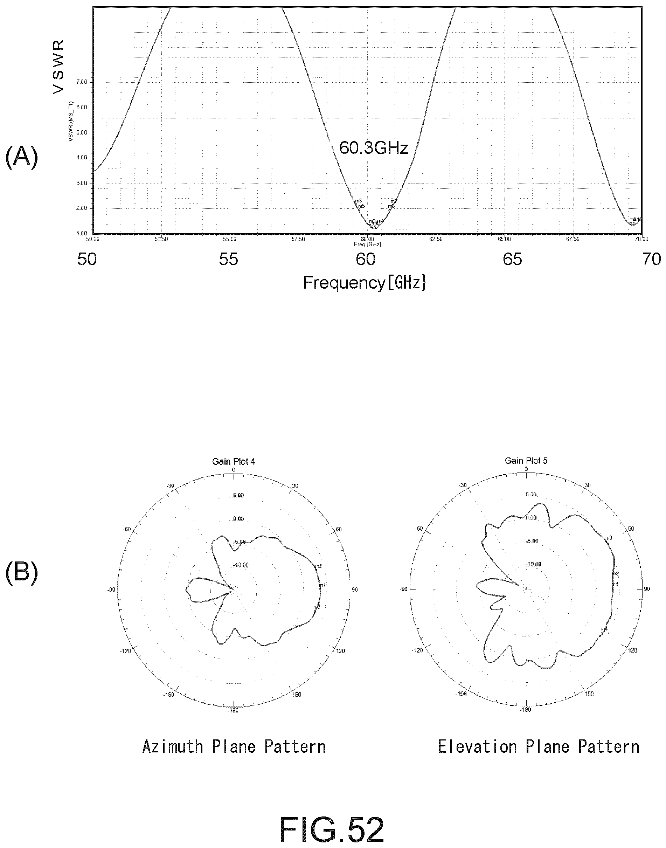

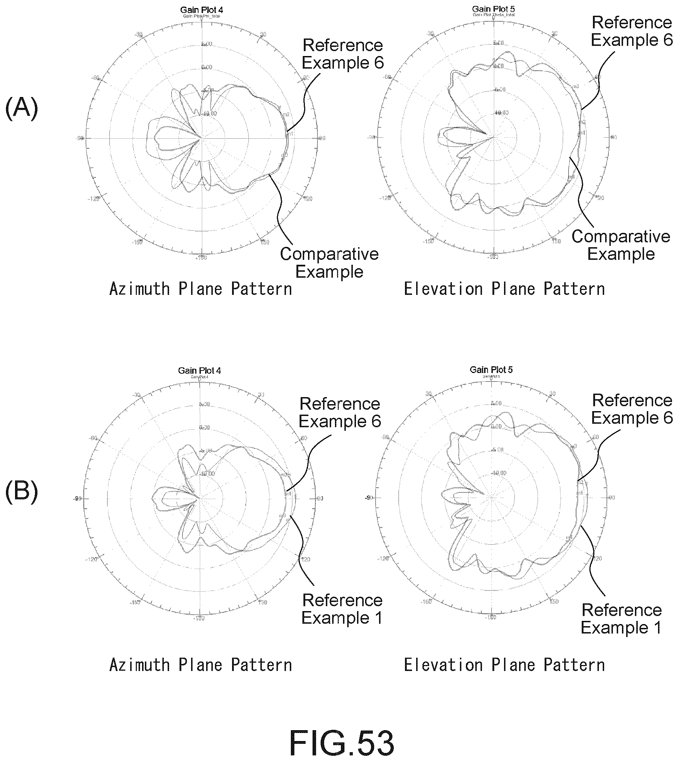

Fig. 52 and Fig. 53 are each a simulation result showing radiation characteristics of the horn antenna 806 according to this example. Part (A) of Fig. 52 shows a voltage standing wave ratio (VSWR), the left side of Part (B) of Fig. 52 shows an azimuth plane pattern, and the right side thereof shows an elevation plane pattern. Note that Part (B) shows radiation patterns at 60.5 GHz.

Part (A) of Fig. 53 is a diagram showing radiation patterns of the horn antenna 806 according to this example (Reference Example 6) and the horn antenna 110 according to the above-mentioned Comparative Example (Fig. 9) in comparison with each other. Part (B) of Fig. 53 is a diagram showing radiation patterns of the horn antenna 806 according to this example (Reference Example 6) and the horn antenna 801 according to the above-mentioned Reference Example 1 in comparison with each other.

As shown in Part (A) of Fig. 52, in accordance with the horn antenna 806 according to this example, the reception frequency was 60.3 GHz, and the receivable band was expanded as compared with that in the Comparative Example.

Further, as shown in Part (A) of Fig. 53, in accordance with this example, the directivity of the main lobe was higher than that in the Comparative Example and the antenna gain was improved.

Meanwhile, as shown in Part (B) of Fig. 53, in accordance with this example, the directivity of the main lobe was lower than that in the Reference Example 1 and the antenna gain was slightly reduced.

### <Reference Example 7>

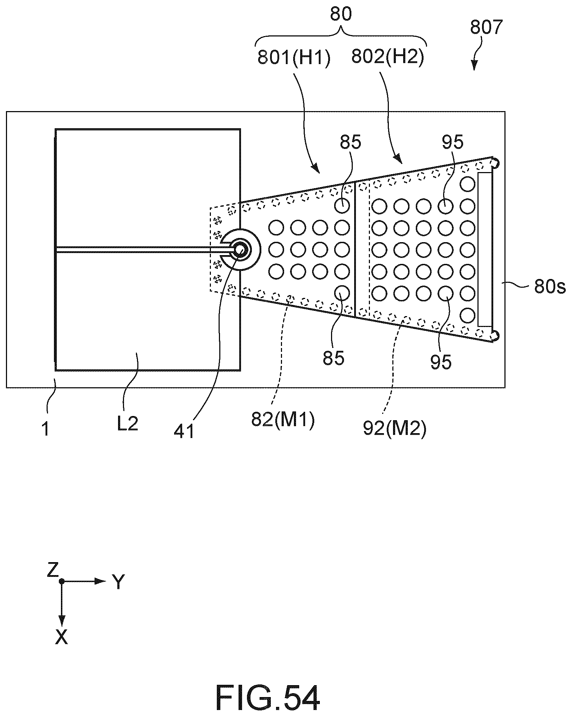

Fig. 54 is a schematic plan view showing a horn antenna 807 according to a Reference Example 7 of the present technology.

Hereinafter, configurations different from those in the Reference Example 2 will be mainly described, configurations similar to those in the Reference Example 2 will be denoted by similar reference symbols, and description thereof is omitted or simplified.

The horn antenna 807 according to this example is different from that in the Reference Example 2 in that the plurality of air hole portions 85 and the plurality of air hole portions 95 are respectively provided in the first and second widening portions 801 and 802 of the horn portion 80. The air hole portions 85 and 95 are formed in the same manner as that in the Reference Examples 5 and 6.

The diameter, array number, and array form of the air hole portions 85 and 95 can be arbitrarily set in accordance with the intended dielectric constant of the first and second waveguides H1 and H2. In this example the diameter of each of the air hole portions 85 and 95 is set to 0.4 mm, and the air hole portions 85 and 95 are respectively formed in the first and second waveguides H1 and H2 such that the entire porosity of the first and second waveguides H1 and H2 is 18.6%. In this case, the dielectric constant of each of the first and second waveguides H1 and H2 changes from 3.6 before forming the air hole portions 95 to 2.93. At this time, the wavelength of a radio wave of 60 GHz propagating through the first and second waveguides H1 and H2 is 3.29 mm.

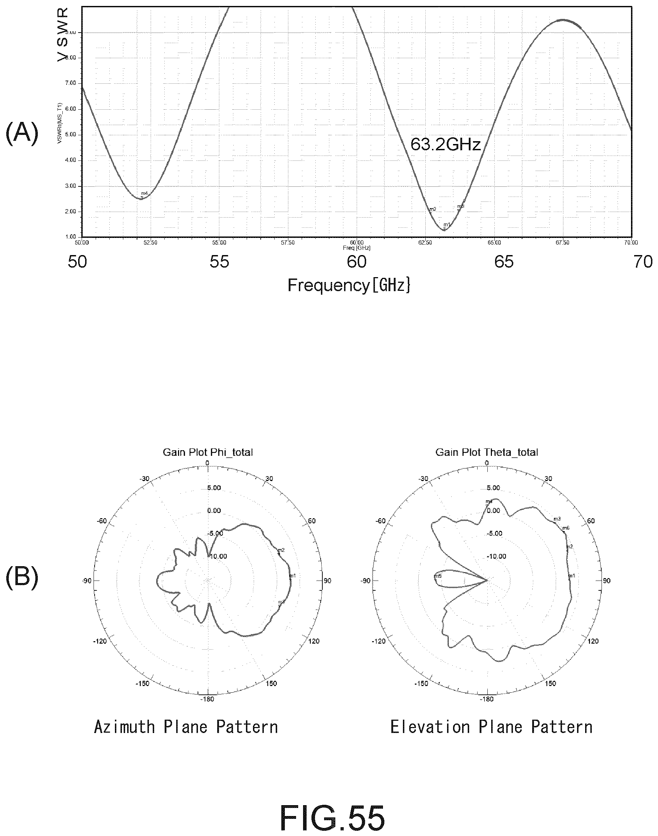

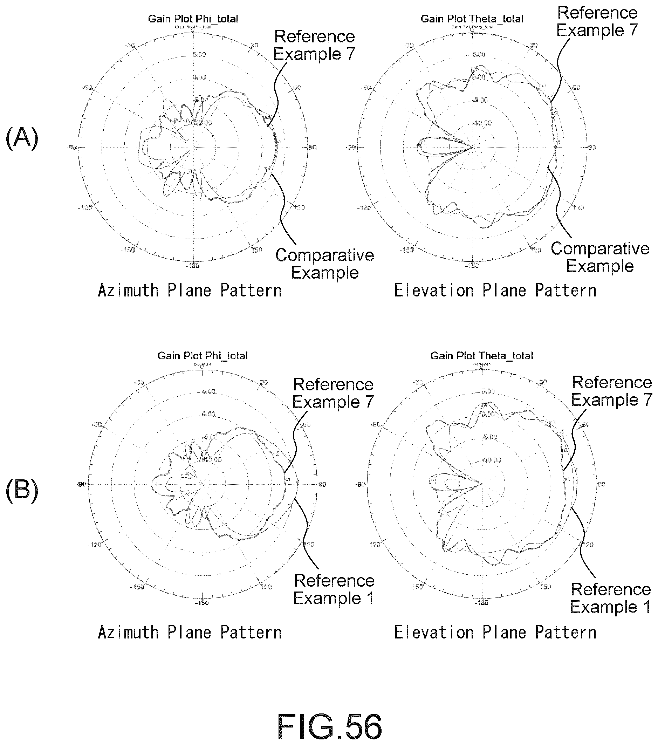

Fig. 55 and Fig. 56 are each a simulation result showing radiation characteristics of the horn antenna 807 according to this example. Part (A) of Fig. 55 shows a voltage standing wave ratio (VSWR), the left side of Part (B) of Fig. 55 shows an azimuth plane pattern, and the right side thereof shows an elevation plane pattern. Note that Part (B) shows radiation patterns at 63.2 GHz.

Part (A) of Fig. 56 is a diagram showing radiation patterns of the horn antenna 807 according to this example (Reference Example 7) and the horn antenna 110 according to the above-mentioned Comparative Example (Fig. 9) in comparison with each other. Part (B) of Fig. 56 is a diagram showing radiation patterns of the horn antenna 807 according to this example (Reference Example 7) and the horn antenna 801 according to the above-mentioned Reference Example 1 in comparison with each other.

As shown in Part (A) of Fig. 55, in accordance with the horn antenna 807 according to this example, the reception frequency was 63.2 GHz, and the receivable band was expanded as compared with that in the Comparative Example.

Further, as shown in Part (A) of Fig. 56, in accordance with this example, the directivity in the right and left direction and the up-and-down direction was enhanced as compared with that in the Comparative Example, and the antenna gain in these directions was improved.

Meanwhile, as shown in Part (B) of Fig. 56, in accordance with this example, the directivity of the main lobe was deteriorated as compared with that in the Reference Example 1, and the antenna gain could not be improved.

### <Reference Example 8>

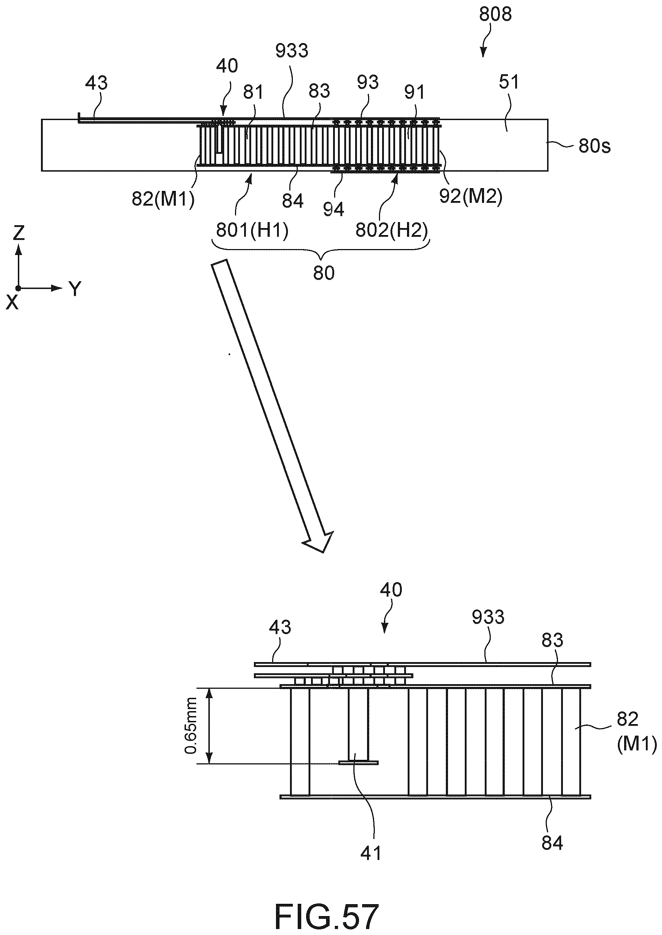

Fig. 57 is a schematic cross-sectional side view showing a horn antenna 808 according to a Reference Example 8 of the present technology and an enlarged view of the power supply unit 40 thereof.

Hereinafter, configurations different from those in the Reference Example 4 will be mainly described, configurations similar to those in the Reference Example 4 will be denoted by similar reference symbols, and description thereof is omitted or simplified.

The horn antenna 808 according to this example is different from that in the Reference Example 4 in the length of the feeding probe 41 protruding from the first conductor layer 83 to the first waveguide H1. In this example, the length was changed from 0.75 mm in the Reference Example 4 to 0.65 mm (λ/4 (0.66 mm) or less). By shortening the length of the feeding probe 41, it is possible to expand the reception frequency band as described below.

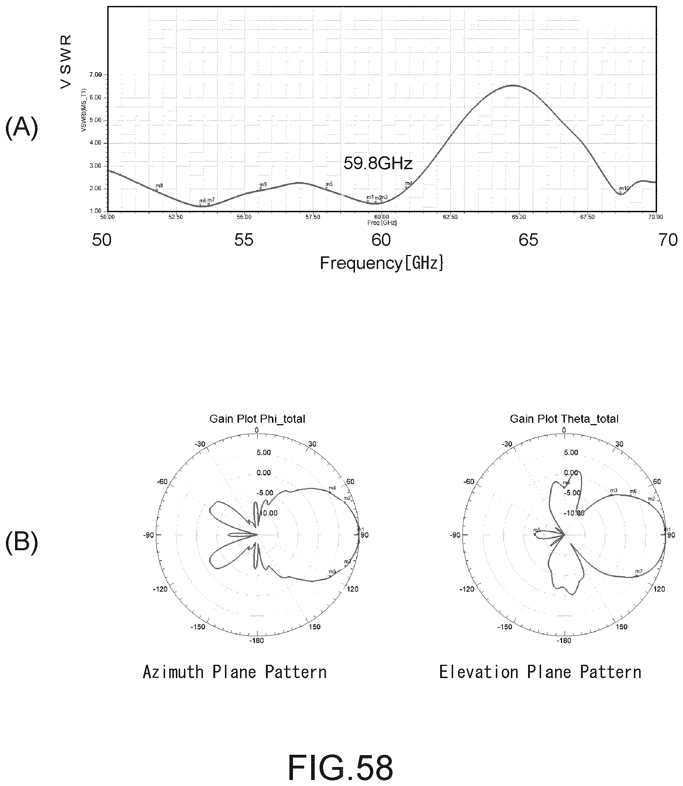

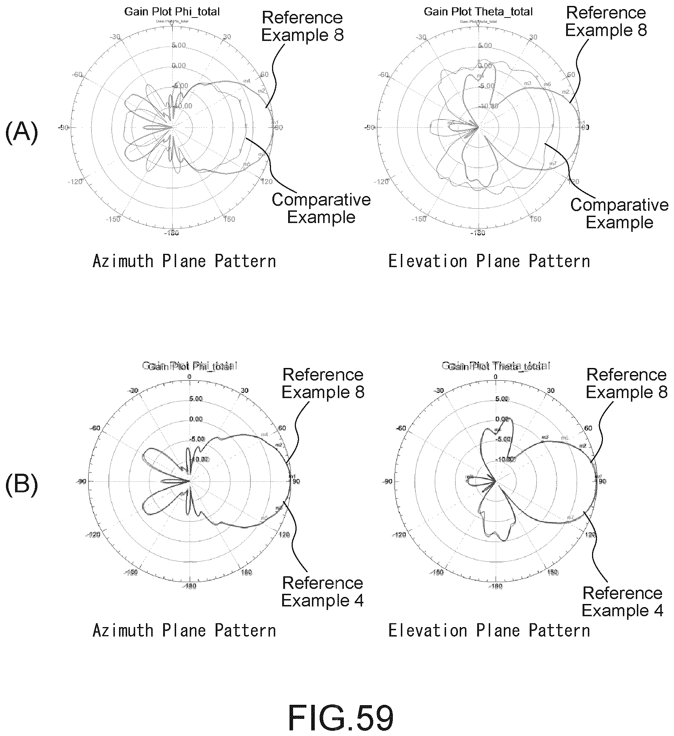

Fig. 58 and Fig. 59 are each a simulation result showing radiation characteristics of the horn antenna 808 according to this example. Part (A) of Fig. 58 shows a voltage standing wave ratio (VSWR), the left side of Part (B) of Fig. 58 shows an azimuth plane pattern, and the right side thereof shows an elevation plane pattern. Note that Part (B) shows radiation patterns at 60.5 GHz.

Part of (A) of Fig. 59 is a diagram showing radiation patterns of the horn antenna 808 according to this example (Reference Example 8) and the horn antenna 110 according to the above-mentioned Comparative Example (Fig. 9) in comparison with each other. Part (B) of Fig. 59 is a diagram showing radiation patterns of the horn antenna 808 according to this example (Reference Example 8) and the horn antenna 803 according to the above-mentioned Reference Example 4 in comparison with each other.

As shown in Part (A) of Fig. 58, in accordance with the horn antenna 808 according to this example, the reception frequency was 59.8 GHz, and the receivable band was significantly expanded as compared with that in the Reference Example 4.

Further, as shown in Part (A) of Fig. 59, in accordance with this example, the directivity of the main lobe was higher than that in the Comparative Example and the antenna gain was significantly improved.

Meanwhile, as shown in Part (B) of Fig. 59, in accordance with this example, there was no significant difference as compared with the Reference Example 4 but the antenna gain was slightly (0.2 dB) improved.

### Reference Signs List

- 1: dielectric multilayer substrate
- 10: waveguide portion
- 11: first dielectric block
- 12: first post wall
- 13, 14: first conductor layer
- 15, 25, 35, 52: air hole portion
- 20: horn portion
- 21: second dielectric block
- 22: second post wall
- 23, 24: second conductor layer
- 31: third dielectric block
- 32: third post wall
- 33, 34: third conductor layer
- 36, 53: dielectric lens portion
- 40: power supply unit

- 41: feeding probe
- 51: dielectric portion
- 100, 200, 300, 400, 500, 600: horn antenna
- 201: first widening portion
- 202: second widening portion
- 700: antenna device

## Claims

1. A horn antenna (100, 200, 300, 400, 500, 600), comprising:
a waveguide portion (10) that includes a first dielectric block (11) and a first post wall (12), the first post wall including a plurality of first conductive columnar bodies that passes through the first dielectric block and demarcating a first waveguide that extends in one axial direction; and
a horn portion (20) that includes a first widening portion (200), the first widening portion being connected to one end of the waveguide portion in the one axial direction and including a second dielectric block (21) that is thicker than the first dielectric block and a second post wall (22) that includes a plurality of second conductive columnar bodies and demarcates a second waveguide whose width increases as a distance from the first waveguide increases, the plurality of second conductive columnar bodies passing through the second dielectric block, wherein
the horn portion further includes a second widening portion (202) that includes
a third dielectric block (31) that is connected to one end of the second dielectric layer in the one axial direction and thicker than the second dielectric block, and
a third post wall (32) that includes a plurality of third conductive columnar bodies and demarcates a third waveguide whose width increases as a distance from the second waveguide increases, the plurality of third conductive columnar bodies passing through the third dielectric block, wherein
the horn portion includes a plurality of air hole portions (15, 25, 35, 52) that is provided in at least one of the second dielectric block or the third dielectric block and has an opening width smaller than a wavelength of an electromagnetic wave penetrating the second dielectric block and the third dielectric block.

2. The horn antenna according to claim 1, wherein
the first dielectric block and the second dielectric block are formed by a common dielectric multilayer substrate, and
the first waveguide and the second waveguide are provided inside the dielectric multilayer substrate.

3. The horn antenna according to claim 1, wherein
the waveguide portion further includes two first conductor layers (13, 14) that face each other across the first dielectric block and are connected to the plurality of first conductive columnar bodies.

4. The horn antenna according to claim 3, wherein
the first widening portion further includes
two second conductor layers (23, 24) that face each other across the second dielectric block and are connected to the plurality of second conductive columnar bodies, and
interlayer connection portions that electrically connect the first conductor layers and the second conductor layers to each other.

5. The horn antenna according to claim 4, further comprising
a conductive shield layer that is connected to one of the first conductor layers and one of the second conductor layers and covers the waveguide portion and the horn portion.

6. The horn antenna according to claim 1, wherein
the waveguide portion includes a plurality of air hole portions that is provided in the first dielectric block and has an opening width smaller than a wavelength of an electromagnetic wave propagating through the first dielectric block.

7. The horn antenna according to claim 1, wherein
the horn portion further includes a dielectric lens portion that is provided on one end of the horn portion in the one axial direction and formed by part of the plurality of air hole portions.

8. The horn antenna according to claim 1, further comprising
a dielectric portion that is connected to one end of the horn portion in the one axial direction and has a length along the one axial direction equal to or greater than one fourth of a wavelength of an electromagnetic wave propagating the second waveguide.

9. The horn antenna according to claim 8, wherein
the dielectric portion includes a plurality of air hole portions having an opening width smaller than a wavelength of an electromagnetic wave propagating the dielectric portion and a dielectric lens portion formed by part of the plurality of air hole portions.

10. The horn antenna according to claim 1, further comprising
a power supply unit (40) that includes a signal line to be connected to the first waveguide.

## Patentansprüche

1. Hornantenne (100, 200, 300, 400, 500, 600), umfassend:
einen Wellenleiterabschnitt (10), der einen ersten dielektrischen Block (11) und eine erste Stützwand (12) einschließt, wobei die erste Stützwand eine Vielzahl von ersten leitfähigen Säulenkörpern einschließt, die durch den ersten dielektrischen Block hindurchgehen und einen ersten Wellenleiter abgrenzen, der sich in einer axialen Richtung erstreckt; und
ein Hornabschnitt (20), der einen ersten verbreiternden Abschnitt (200) einschließt, wobei der erste verbreiternde Abschnitt in einer axialen Richtung mit einem Ende des Wellenleiterabschnitts verbunden ist und einen zweiten dielektrischen Block (21) einschließt, der dicker als der erste dielektrische Block ist, und eine zweite Stützwand (22), die eine Vielzahl von zweiten leitfähigen Säulenkörpern einschließt und einen zweiten Wellenleiter abgrenzt, dessen Breite mit einem zunehmendem Abstand von dem ersten Wellenleiter zunimmt, wobei die Vielzahl von zweiten leitfähigen Säulenkörpern durch den zweiten dielektrischen Block hindurchverläuft, wobei
der Hornabschnitt ferner einen zweiten verbreiternden Abschnitt (202) einschließt, der einschließt
einen dritten dielektrischen Block (31), der in einer axialen Richtung mit einem Ende der zweiten dielektrischen Schicht verbunden und dicker als der zweite dielektrische Block ist, und
eine dritte Stützwand (32), die eine Vielzahl von dritten leitfähigen Säulenkörpern einschließt und einen dritten Wellenleiter abgrenzt, dessen Breite mit einem zunehmendem Abstand von dem zweiten Wellenleiter zunimmt, wobei die Vielzahl von dritten leitfähigen Säulenkörpern durch den dritten dielektrischen Block hindurchverläuft, wobei
der Hornabschnitt eine Vielzahl von Luftlochabschnitten (15, 25, 35, 52) einschließt, die in mindestens einem des zweiten dielektrischen Blocks oder des dritten dielektrischen Blocks bereitgestellt ist und eine Öffnungsbreite aufweist, die kleiner als eine Wellenlänge einer elektromagnetischen Welle ist, die den zweiten dielektrischen Block und den dritten dielektrischen Block durchdringt.

2. Hornantenne nach Anspruch 1, wobei
der erste dielektrische Block und der zweite dielektrische Block durch ein gemeinsames dielektrisches Mehrschichtsubstrat ausgebildet werden, und
der erste Wellenleiter und der zweite Wellenleiter im Inneren des dielektrischen Mehrschichtsubstrats bereitgestellt sind.

3. Hornantenne nach Anspruch 1, wobei
der Wellenleiterabschnitt ferner zwei erste Leiterschichten (13, 14) einschließt, die über den ersten dielektrischen Block hinweg einander zugewandt sind und mit der Vielzahl von ersten leitfähigen Säulenkörpern verbunden sind.

4. Hornantenne nach Anspruch 3, wobei
der erste verbreiternde Abschnitt ferner einschließt
zwei zweite Leiterschichten (23, 24), die über den zweiten dielektrischen Block hinweg einander zugewandt sind und mit der Vielzahl von zweiten leitfähigen Säulenkörpern verbunden sind, und
Zwischenschichtverbindungsabschnitte, die die ersten Leiterschichten und die zweiten Leiterschichten elektrisch miteinander verbinden.

5. Hornantenne nach Anspruch 4, ferner umfassend
eine leitfähige Schirmschicht, die mit einer der ersten Leiterschichten und einer der zweiten Leiterschichten verbunden ist und den Wellenleiterabschnitt und den Hornabschnitt abdeckt.

6. Hornantenne nach Anspruch 1, wobei
der Wellenleiterabschnitt eine Vielzahl von Luftlochabschnitten einschließt, die in dem ersten dielektrischen Block bereitgestellt ist und eine Öffnungsbreite aufweist, die kleiner als eine Wellenlänge einer elektromagnetischen Welle ist, die sich durch den ersten dielektrischen Block hindurch ausbreitet.

7. Hornantenne nach Anspruch 1, wobei
der Hornabschnitt ferner einen dielektrischen Linsenabschnitt einschließt, der an einem Ende des Hornabschnitts in einer axialen Richtung bereitgestellt und durch einen Teil der Vielzahl von Luftlochabschnitten ausgebildet wird.

8. Hornantenne nach Anspruch 1, ferner umfassend
einen dielektrischen Abschnitt, der mit einem Ende des Hornabschnitts in einer axialen Richtung verbunden ist und eine Länge entlang der einen axialen Richtung aufweist, die gleich oder größer als ein Viertel der Wellenlänge einer elektromagnetischen Welle ist, die sich in dem zweiten Wellenleiter ausbreitet.

9. Hornantenne nach Anspruch 8, wobei
der dielektrische Abschnitt eine Vielzahl von Luftlochabschnitten einschließt, die eine Öffnungsweite, die kleiner als eine Wellenlänge einer elektromagnetischen Welle ist, die sich in dem dielektrischen Abschnitt ausbreitet, und einen dielektrischen Linsenabschnitt einschließt, der durch einen Teil der Vielzahl von Luftlochabschnitten ausgebildet wird.

10. Hornantenne nach Anspruch 1, ferner umfassend
eine Stromversorgungseinheit (40), die eine Signalleitung einschließt, um mit dem ersten Wellenleiter verbunden zu werden.

## Revendications

1. Antenne à cornet (100, 200, 300, 400, 500, 600), comprenant :
une partie de guide d'ondes (10) qui comporte un premier bloc diélectrique (11) et une première paroi de poteau (12), la première paroi de poteau comportant une pluralité de premiers corps colonnaires conducteurs qui passent à travers le premier bloc diélectrique et délimitant un premier guide d'ondes qui s'étend dans une direction axiale ; et
une partie de cornet (20) qui comporte une première partie d'élargissement (200), la première partie d'élargissement étant connectée à une extrémité de la partie de guide d'ondes dans une direction axiale et comportant un deuxième bloc diélectrique (21) qui est plus épais que le premier bloc diélectrique et une deuxième paroi de poteau (22) qui comporte une pluralité de deuxièmes corps colonnaires conducteurs et délimite un deuxième guide d'ondes dont la largeur augmente à mesure qu'une distance par rapport au premier guide d'ondes augmente, la pluralité de deuxièmes corps colonnaires conducteurs passant à travers le deuxième bloc diélectrique, dans laquelle
la partie de cornet comporte en outre une deuxième partie d'élargissement (202) qui comporte
un troisième bloc diélectrique (31) qui est connecté à une extrémité de la seconde couche diélectrique dans la direction axiale et est plus épais que le deuxième bloc diélectrique, et
une troisième paroi de poteau (32) qui comporte une pluralité de troisièmes corps colonnaires conducteurs et délimite un troisième guide d'ondes dont la largeur augmente à mesure qu'une distance par rapport au deuxième guide d'ondes augmente, la pluralité de troisièmes corps colonnaires conducteurs passent à travers le troisième bloc diélectrique, dans laquelle
la partie de cornet comporte une pluralité de parties d'orifice d'air (15, 25, 35, 52) qui sont prévues dans au moins l'un du deuxième bloc diélectrique ou du troisième bloc diélectrique et ont une largeur d'ouverture plus petite qu'une longueur d'onde d'une onde électromagnétique pénétrant le deuxième bloc diélectrique et le troisième bloc diélectrique.

2. Antenne à cornet selon la revendication 1, dans laquelle
le premier bloc diélectrique et le deuxième bloc diélectrique sont formés par un substrat multicouche diélectrique commun, et
le premier guide d'ondes et le deuxième guide d'ondes sont prévus à l'intérieur du substrat multicouche diélectrique.

3. Antenne à cornet selon la revendication 1, dans laquelle
la partie de guide d'ondes comporte en outre deux premières couches conductrices (13, 14) qui se font face à travers le premier bloc diélectrique et sont connectées à la pluralité de premiers corps colonnaires conducteurs.

4. Antenne à cornet selon la revendication 3, dans laquelle
la première partie d'élargissement comporte en outre
deux secondes couches conductrices (23, 24) qui se font face à travers le deuxième bloc diélectrique et sont connectées à la pluralité de deuxièmes corps colonnaires conducteurs, et
des parties de connexion intercouches qui connectent électriquement les premières couches conductrices et les secondes couches conductrices les unes aux autres.

5. Antenne à cornet selon la revendication 4, comprenant en outre
une couche de blindage conductrice qui est connectée à l'une des premières couches conductrices et à l'une des secondes couches conductrices et recouvre la partie de guide d'ondes et la partie de cornet.

6. Antenne à cornet selon la revendication 1, dans laquelle
la partie de guide d'ondes comporte une pluralité de parties d'orifice d'air qui sont prévues dans le premier bloc diélectrique et ont une largeur d'ouverture plus petite qu'une longueur d'onde d'une onde électromagnétique se propageant à travers le premier bloc diélectrique.

7. Antenne à cornet selon la revendication 1, dans laquelle
la partie de cornet comporte en outre une partie de lentille diélectrique qui est prévue sur une extrémité de la partie de cornet dans la direction axiale et formée par une partie de la pluralité de parties d'orifice d'air.

8. Antenne à cornet selon la revendication 1, comprenant en outre
une partie diélectrique qui est connectée à une extrémité de la partie de cornet dans la direction axiale et a une longueur le long de la direction axiale égale ou supérieure à un quart d'une longueur d'onde d'une onde électromagnétique se propageant dans le deuxième guide d'ondes.

9. Antenne à cornet selon la revendication 8, dans laquelle
la partie diélectrique comporte une pluralité de parties d'orifice d'air ayant une largeur d'ouverture inférieure à une longueur d'onde d'une onde électromagnétique se propageant dans la partie diélectrique et une partie de lentille diélectrique formée par une partie de la pluralité de parties d'orifice d'air.

10. Antenne à cornet selon la revendication 1, comprenant en outre
une unité d'alimentation (40) qui comporte une ligne de signal à connecter au premier guide d'ondes.
